(19)

Europäisches Patentamt
European Patent Office
Office européen des brevets

(11) EP 1 879 219 A1

(12) **EUROPEAN PATENT APPLICATION**
published in accordance with Art. 153(4) EPC

(43) Date of publication:
16.01.2008 Bulletin 2008/03

(51) Int Cl.:
H01L 21/027 (2006.01)   G03F 7/20 (2006.01)

(21) Application number: 06745676.4

(86) International application number:
PCT/JP2006/308648

(22) Date of filing: 25.04.2006

(87) International publication number:
WO 2006/118108 (09.11.2006 Gazette 2006/45)

(84) Designated Contracting States:
AT BE BG CH CY CZ DE DK EE ES FI FR GB GR
HU IE IS IT LI LT LU LV MC NL PL PT RO SE SI
SK TR

(72) Inventor: NAGASAKA, Hiroyuki,
NIKON CORPORATION
Tokyo 1008331 (JP)

(30) Priority: 27.04.2005  JP 2005129517
21.07.2005  JP 2005211319

(74) Representative: HOFFMANN EITLE
Patent- und Rechtsanwälte
Arabellastrasse 4
81925 München (DE)

(71) Applicant: NIKON CORPORATION
Tokyo 100-8331 (JP)

(54) **EXPOSURE METHOD, EXPOSURE APPARATUS, METHOD FOR MANUFACTURING DEVICE, AND FILM EVALUATION METHOD**

(57)   An exposing method has: a process that forms an immersion region (LR) of a liquid (LQ) on a substrate (P); a process that determines exposure conditions in accordance with an adhesive force that acts between a surface of the substrate (P) and the liquid (LQ); and a process that, based on the exposure conditions, exposes the substrate (P) through the liquid (LQ) of the immersion region (LR).

FIG. 1

## Description

TECHNICAL FIELD

The present invention relates to an exposing method, an exposure apparatus, and a device fabricating method that expose a substrate through a liquid, as well as to a film evaluating method.

Priority is claimed on Japanese Patent Application No. 2005-129517, filed April 27, 2005, and Japanese Patent Application No. 2005-211319, filed July 21, 2005, the contents of which are incorporated herein by reference.

BACKGROUND ART

The photolithographic process, which is one of the processes for fabricating microdevices such as semiconductor devices and liquid crystal display devices, uses an exposure apparatus that projects and exposes a pattern formed on a mask onto a photosensitive substrate. This exposure apparatus comprises a mask stage that supports the mask as well as a substrate stage that supports the substrate, and projects and exposes the pattern of the mask onto the substrate through a projection optical system while successively moving the mask stage and the substrate stage. In the field of microdevice fabrication, there is demand to increase the fineness of the patterns formed on substrates in order to increase device density. There is also a demand to increase the resolution of exposure apparatuses in order to meet this need; furthermore, as one means to achieve increased resolution, an immersion exposure apparatus has been proposed that forms a liquid immersion region of liquid on the substrate and then exposes the substrate through the liquid of that liquid immersion region, as disclosed in Patent Document 1 below.

[Patent Document 1] PCT International Publication No. WO99/49504

DISCLOSURE OF INVENTION

PROBLEMS TO BE SOLVED BY THE INVENTION

Incidentally, a variety of materials are normally used in, for example, a photoresist film that is provided to the surface of the substrate to be exposed or in a topcoat film that is provided to a layer that is on top of the photoresist film; however, the film constitutes the surface that contacts the liquid of the immersion region, and if the type of film changes, then there is a chance that, depending on the type of the film, it will no longer be possible to maintain the liquid along the optical path of the exposure light in a desired state. In this case, a problem occurs wherein the versatility of the immersion exposure apparatus is remarkably reduced.

The present invention considers such circumstances, and it is an object of the present invention to provide an exposing method, an exposure apparatus, and a device fabricating method that can satisfactorily perform immersion exposures with respect to substrates that are provided with films of different types.

MEANS FOR SOLVING THE PROBLEM

To solve the abovementioned problems, the present invention adopts the following constitution that corresponds to the drawings, which describe the embodiments. However, any parenthesized symbol appended to an element is merely for the purpose of illustrating the element, and that element is not limited thereby.

In accordance with a first aspect of the present invention, there is provided an exposing method that exposes a substrate (P) by forming an immersion region (LR) of a liquid (LQ) on the substrate (P) and irradiating the substrate (P) with exposure light (EL) through the liquid (LQ) of the immersion region (LR), comprising determining exposure conditions to be used during the exposure of the substrate (P) in accordance with an adhesive force that acts between a surface of the substrate (P) and the liquid (LQ).

According to the first aspect of the present invention, the exposure conditions to be used during the exposure of the substrate are determined in accordance with the adhesive force that acts between the surface of the substrate and the liquid, which makes it possible to perform an immersion exposure of the substrate satisfactorily, regardless of the type of film on the surface.

In accordance with a second aspect of the present invention, there is provided an exposing method that exposes a substrate (P) by forming an immersion region (LR) of a liquid (LQ) on the substrate (P) and irradiating the substrate (P) with exposure light (EL) through the liquid (LQ) of the immersion region (LR), comprising determining exposure conditions to be used during the exposure of the substrate (P) based on a static contact angle of the liquid (LQ) on the surface of the substrate (P) and a sliding angle of the liquid (LQ) on the surface of the substrate (P).

According to the second aspect of the present invention, the exposure conditions to be used during the exposure of the substrate are determined based on the static contact angle and the sliding angle of the liquid on the surface of the substrate, which makes it possible to perform an immersion exposure of the substrate satisfactorily, regardless of the type of film on the surface.

In accordance with a third aspect of the present invention, there is provided an exposing method that exposes a substrate (P) by forming an immersion region (LR) of a liquid (LQ) on the substrate (P) and irradiating the substrate (P) with exposure light (EL) through the liquid (LQ) of the immersion region (LR), comprising determining exposure conditions to be used during the exposure of the substrate (P) based on a receding contact angle of the liquid (LQ) on the surface of the substrate (P) when the surface of the substrate (P) is inclined.

According to the third aspect of the present invention, the exposure conditions to be used during the exposure of the substrate are determined based on the receding contact angle of the liquid on the surface of the substrate when the surface of the substrate is inclined, which makes it possible to perform an immersion exposure of the substrate satisfactorily, regardless of the type of film on the surface.

In accordance with a fourth aspect of the present invention, there is provided a device fabricating method wherein an exposing method according to the abovementioned aspects of the invention is used.

According to the fourth aspect of the present invention, regardless of the type of film on the surface, it is possible to perform an immersion exposure of the substrate satisfactorily, which makes it possible to fabricate a device that has a desired performance.

In accordance with a fifth aspect of the present invention, there is provided an exposure apparatus (EX) that exposes a substrate (P) by forming an immersion region (LR) of a liquid (LQ) on the substrate (P) and irradiating the substrate (P) with exposure light (EL) through the liquid (LQ) of the immersion region (LR), comprising a measuring apparatus (60) that measures an adhesive force that acts between a surface of the substrate (P) and the liquid (LQ).

According to the fifth aspect of the present invention, the adhesive force that acts between the surface of the substrate and the liquid is measured, which makes it possible to perform an immersion exposure of the substrate satisfactorily based on that measurement result, regardless of the type of film on the surface.

In accordance with a sixth aspect of the present invention, there is provided an exposure apparatus (EX) that exposes a substrate (P) by forming an immersion region (LR) of a liquid (LQ) on the substrate (P) and irradiating the substrate (P) with exposure light (EL) through the liquid (LQ) of the immersion region (LR), comprising a measuring apparatus (60) that measures a receding contact angle of the liquid (LQ) on the surface of the substrate (P) when the surface of the substrate (P) is inclined.

According to the sixth aspect of the present invention, the receding contact angle of the liquid on the surface of the substrate is measured when the surface of the substrate is inclined, which makes it possible to perform an immersion exposure of the substrate satisfactorily based on that measurement result, regardless of the type of film on the surface.

In accordance with a seventh aspect of the present invention, there is provided an exposure apparatus (EX) that exposes a substrate (P) by forming an immersion region (LR) of a liquid (LQ) on the substrate (P) and irradiating the substrate (P) with exposure light (EL) through the liquid (LQ) of the immersion region (LR), comprising: a first measuring apparatus (60) that measures a static contact angle of the liquid (LQ) on a surface of the substrate (P); a second measuring apparatus (60) that measures a sliding angle of the liquid (LQ) on the surface of the substrate (P); and a control apparatus (CONT) that determines exposure conditions to be used during the exposure of the substrate (P) based on a measurement result of the first measuring apparatus (60) and on a measurement result of the second measuring apparatus (60).

According to the seventh aspect of the present invention, the exposure conditions to be used during the exposure of the substrate are determined based on the static contact angle and the sliding angle of the liquid on the surface of the substrate, which are measured by the first and second measuring apparatuses; thus, it is possible to perform an immersion exposure of the substrate satisfactorily, regardless of the type of film on the surface.

In accordance with an eighth aspect of the present invention, there is provided an exposure apparatus (EX) that exposes a substrate (P) by forming an immersion region (LR) of a liquid (LQ) on the substrate (P) and irradiating the substrate (P) with exposure light (EL) through the liquid (LQ) of the immersion region (LR), comprising: an input apparatus (INP) that inputs information regarding a static contact angle of the liquid (LQ) on a surface of the substrate (P), and information regarding a sliding angle of the liquid (LQ) on the surface of the substrate (P); and a control apparatus (CONT) that determines exposure conditions to be used during the exposure of the substrate (P) based on the information regarding the contact angle and the information regarding the sliding angle that were input from the input apparatus (INP).

According to the eighth aspect of the present invention, the exposure conditions to be used during the exposure of the substrate are determined based on the information regarding the static contact angle and regarding the sliding angle of the liquid on the surface of the substrate that were input by the input apparatus, which makes it possible to perform immersion exposure of the substrate, regardless of the type of film on the surface.

In accordance with a ninth aspect of the present invention, there is provided an exposure apparatus (EX) that exposes a substrate (P) by forming an immersion region (LR) of a liquid (LQ) on the substrate (P) and irradiating the substrate (P) with exposure light (EL) through the liquid (LQ) of the immersion region (LR), comprising: an input apparatus (INP) that inputs information regarding a receding contact angle of the liquid (LQ) on a surface of the substrate (P) when the surface of the substrate (P) is inclined; and a control apparatus (CONT) that determines exposure conditions to be used during the exposure of the substrate (P) based on the information regarding the receding contact angle that was input from the input apparatus (INP).

According to the ninth aspect of the present invention, the exposure conditions to be used during the exposure of the substrate are determined based on the information regarding the receding contact angle of the liquid on the surface of the substrate when the surface of the substrate is inclined, which was input by the input apparatus, and therefore it is possible to perform an immersion exposure of the substrate satisfactorily, regardless of the type of film on the surface.

In accordance with a tenth aspect of the present invention, there is provided a device fabricating method wherein an exposure apparatus (EX) according to the abovementioned aspects is used.

According to the tenth aspect of the present invention, it is possible to perform an immersion exposure of each substrate of a plurality of substrates, wherein each substrate is provided with a different type of film, satisfactorily, and it is therefore possible to fabricate a device that has a desired performance.

EFFECTS OF THE INVENTION

According to the present invention, it is possible to perform an immersion exposure of a plurality of substrates satisfactorily, wherein each substrate is provided with a different type of film.

BRIEF DESCRIPTION OF THE DRAWINGS

FIG. 1 is a schematic block diagram that shows one embodiment of the exposure apparatus.
FIG. 2 is a diagram that explains the positional relationship between an immersion region and a substrate when the substrate is exposed.
FIG. 3A is a cross sectional view that shows one example of the substrate.
FIG. 3B is a cross sectional view that shows one example of the substrate.
FIG. 4 is a diagram that shows one embodiment of a measuring apparatus.
FIG. 5 is a view that explains adhesive force.
FIG. 6 is a flow chart diagram that explains one embodiment of an exposing method.
FIG. 7 shows the results of a test that was conducted in order to derive the relationship of permissible speed versus a static contact angle and a sliding angle.
FIG. 8 is a chart that shows the relationship of the permissible speed versus the static contact angle and the sliding angle.
FIG. 9 is a diagram that explains a receding contact angle.
FIG. 10 shows the results of a test that was conducted in order to derive the relationship between the receding contact angle and the permissible speed.
FIG. 11 is a chart that shows the relationship of the permissible speed versus the receding contact angle and the sliding angle.
FIG. 12 is a flow chart diagram for explaining one example of a process of fabricating a microdevice.

DESCRIPTION OF THE REFERENCE SYMBOLS

| | |
|---|---|
| 1 | Liquid immersion mechanism |
| 60 | Measuring apparatus |
| CONT | Control apparatus |
| EL | Exposure light |
| EX | Exposure apparatus |
| INP | Input apparatus |
| LQ | Liquid |
| LR | Immersion region |
| MRY | Storage apparatus |
| P | Substrate |
| PST | Substrate stage |

BEST MODE FOR CARRYING OUT THE INVENTION

The following explains the embodiments of the present invention, referencing the drawings, but the present invention is not limited thereto.

<First Embodiment>

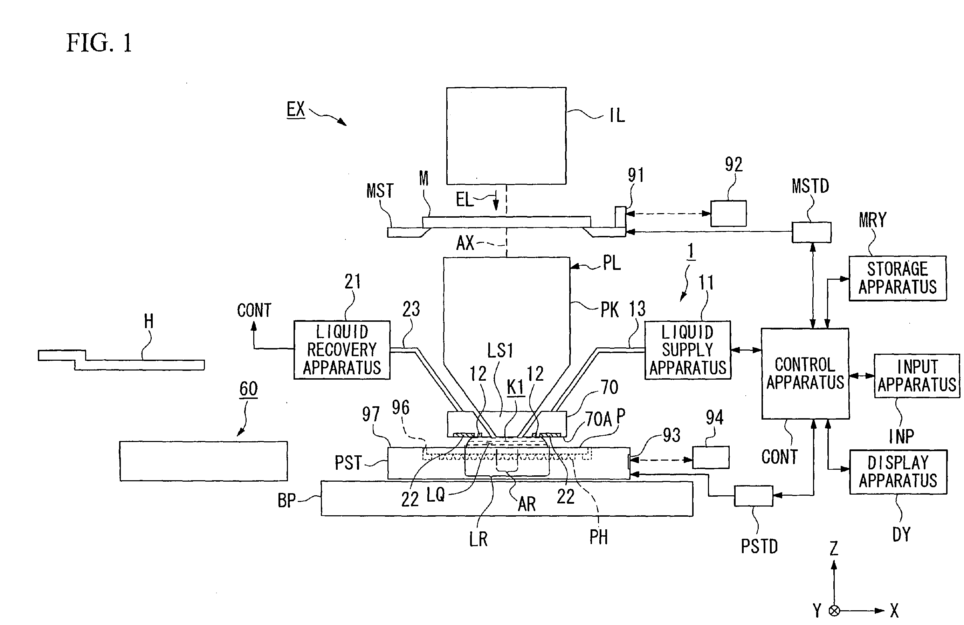

The first embodiment will now be explained. FIG. 1 is a schematic block diagram that shows an exposure apparatus EX according to a first embodiment. In FIG. 1, the exposure apparatus EX comprises a mask stage MST, which is capable of holding and moving a mask M; a substrate stage PST that has a substrate holder PH, which holds a substrate P, and is capable of moving such; an illumination optical system IL, which illuminates the mask M supported by the mask stage MST with exposure light EL; a projection optical system PL, which projects a pattern image of the mask M that is illuminated by the exposure light EL onto the substrate P; and a control apparatus CONT, which controls the operation of the entire exposure apparatus EX. A storage apparatus MRY that stores information related to the exposure process, an input apparatus INP that inputs information related to the exposure process, and a display apparatus DY that displays information related to the exposure process are connected to the control apparatus CONT. The input apparatus INP comprises, for example, a keyboard or a touch panel. The display apparatus DY comprises a display apparatus such as a liquid crystal display. In addition, the exposure apparatus EX comprises a transport apparatus H that transports the substrate P to the substrate stage PST.

The exposure apparatus EX of the present embodiment is a liquid immersion exposure apparatus that employs the liquid immersion method to shorten the exposure wavelength substantially, improve the resolution, as well as increase the depth of focus substantially, and comprises a liquid immersion mechanism 1 for filling an optical path space K1, which is in the optical path of the exposure light EL in the vicinity of the image plane of the projection optical system PL, with a liquid LQ. The liquid immersion mechanism 1 comprises: a nozzle member 70, which is provided in the vicinity of the optical path space K1 and has supply ports 12 that supply the liquid LQ and recovery ports 22 that recover such; a liquid supply apparatus 11 that supplies the liquid LQ through a supply pipe 13 and the supply ports 12 provided to the a nozzle member 70; and a liquid recovery apparatus 21 that recovers the liquid LQ through the recovery ports 22, which are provided to the nozzle member 70, and a recovery pipe 23. The nozzle member 70 is formed annularly above the substrate P (substrate stage PST) so that it surrounds a last optical element LS1, which is the element of the plurality of optical elements that constitute the projection optical system PL that is closest to the image plane of the projection optical system PL.

In addition, the exposure apparatus EX of the present embodiment employs a local liquid immersion system that locally forms an immersion region LR, which is larger than a projection area AR of the projection optical system PL and smaller than the substrate P, in some area of the substrate P that includes the projection area AR. At least while the pattern image of the mask M is projected onto the substrate P, the exposure apparatus EX forms the immersion region LR of the liquid LQ on the substrate P by using the liquid immersion mechanism 1 to fill the optical path space K1 of the exposure light EL between the last optical element LS1, which is closest to the image plane of the projection optical system PL, and the substrate P, which is disposed at a position that opposes the last optical element LS1, with the liquid LQ, and projects the pattern image of the mask M onto the substrate P by irradiating the substrate P with the exposure light EL, which passed through the mask M, through the projection optical system PL and the liquid LQ of the immersion region LR. The control apparatus CONT locally forms the immersion region LR of the liquid LQ in some area of the substrate P by using the liquid supply apparatus 11 of the liquid immersion mechanism 1 to supply a prescribed amount of the liquid LQ and the liquid recovery apparatus 21 to recover a prescribed amount of the liquid LQ so as to fill the optical path space K1 with the liquid LQ.

Furthermore, the present embodiment explains a case wherein the immersion region LR is formed on the substrate P, but it is also possible to form such on an object that is disposed at a position on the image plane side of the projection optical system PL that opposes the last optical element LS 1 such as an upper surface of the substrate stage PST that includes the substrate P.

In addition, the exposure apparatus EX comprises a measuring apparatus 60 that measures the adhesive force (adhesive energy) that acts between the liquid LQ and the front surface of the substrate P. In the present embodiment, the measuring apparatus 60 is provided along the transport pathway of the transport apparatus H.

The present embodiment will now be explained by taking as an example a case of using a scanning type exposure apparatus (a so-called scanning stepper) as the exposure apparatus EX that exposes the substrate P with the pattern formed in the mask M, while synchronously moving the mask M and the substrate P in their respective scanning directions. In the following explanation, the directions in which the mask M and the substrate P synchronously move (the scanning directions) within the horizontal plane are the Y axial directions, the directions orthogonal to the Y axial directions within the horizontal plane are the X axial directions (the non-scanning directions), and the directions that are perpendicular to the X and Y axial directions and that coincide with the optical axis AX of the projection optical system PL are the Z axial directions. In addition, the rotational (the inclined) directions about the X, Y, and Z axes are the θX, θY, and θZ directions, respectively. Furthermore, "substrate" herein includes, for example, a base material, such as a semiconductor wafer, that is coated with a photosensitive material (a photoresist), and "mask" includes a reticle wherein a device pattern is formed that is reduction projected onto the substrate.

The illumination optical system IL comprises: an exposure light source; an optical integrator that uniformizes the luminous flux intensity of the light beam emitted from the exposure light source; a condenser lens that condenses the exposure light EL from the optical integrator; a relay lens system; and a field stop that sets an illumination region on the mask M that is illuminated by the exposure light EL. The illumination optical system IL illuminates the prescribed illumination region on the mask M with the exposure light EL, which has a uniform luminous flux intensity distribution. Examples of light that can be used as the exposure light EL emitted from the illumination optical system IL include: deep ultraviolet light (DUV light) such as bright line (g-line, h-line, or i-line) light emitted from, for example, a mercury lamp, and KrF excimer laser light (248 nm wavelength); and vacuum ultraviolet light (VUV light), such as ArF excimer laser light (193 nm wavelength) and $F_2$ laser light (157 nm wavelength). ArF excimer laser light is used in the present embodiment.

In the present embodiment, pure water is used as the liquid LQ. Pure water is capable of transmitting not only ArF excimer laser light, but also deep ultraviolet light (DUV light), such as bright line (g, h, and i lines) light emitted from a mercury lamp and the like, and KrF excimer laser light (248 nm wavelength).

The mask stage MST is capable of holding and moving the mask M. The mask stage MST uses, for example, a vacuum chucking (or electrostatic chucking) mechanism to hold the mask M. The mask stage MST, in a state wherein it holds the mask M, can be moved in two dimensions within a plane that is perpendicular to the optical axis AX of the projection optical system PL, i.e., within the XY plane, and can be finely rotated in the θZ directions by the drive of a mask stage drive mechanism MSTD, which includes a linear motor that is controlled by the control apparatus CONT. Movable mirrors 91 are provided on the mask stage MST. In addition, laser interferometers 92 are provided at prescribed positions The laser interferometers 92 use the movable mirrors 91 to measure in real time the positions of the mask M on the mask stage MST in the two dimensional directions, as well as the rotational angle in the θZ directions (depending on the case, including the rotational angles in the θX and θY directions). The measurement results of the laser interferometers 92 are output to the control apparatus CONT. Based on the measurement results of the laser interferometers 92, the control apparatus CONT controls the position of the mask M, which is held by the mask stage MST, by driving the mask stage drive mechanism MSTD.

The projection optical system PL exposes the substrate P by projecting the pattern of the mask M thereon at a prescribed projection magnification β, and comprises a plurality of optical elements, which are held by a lens barrel PK. In the present embodiment, the projection optical system PL is a reduction system that has a projection magnification β of, for example, 1/4, 1/5 or 1/8. Furthermore, the projection optical system PL may also be a unity magnification system or an enlargement system. In addition, the projection optical system PL may be: a dioptric system that does not include catoptric elements; a catoptric system that does not include dioptric elements; or a catadioptric system that includes both catoptric elements and dioptric elements. In addition, in the present embodiment, the plurality of optical elements that constitute the projection optical system PL are held by the lens barrel PK so that just the last optical element LS1, which is closest to the image plane of the projection optical system PL, contacts the liquid LQ.

The substrate stage PST comprises the substrate holder PH, which holds the substrate P, and is capable of moving on the image plane side of the projection optical system PL on a base member BP. The substrate holder PH uses, for example, a vacuum chucking mechanism to hold the substrate P. A recessed part 96 is provided on the substrate stage PST, and the substrate holder PH that holds the substrate P is disposed in the recessed part 96. Furthermore, an upper surface 97 of the substrate stage PST, with the exception of the recessed part 96, is formed as a flat surface so that it is at substantially the same height as (flush with) the front surface of the substrate P that is held by the substrate holder PH. Furthermore, provided that it is possible to continue to fill the optical path space K1 with the liquid LQ, there may be a step between the upper surface 97 of the substrate stage PST and the front surface of the substrate P that is held by the substrate holder PH.

In the state wherein the substrate P is held via the substrate holder PH, the substrate stage PST can be moved in two dimensions within the XY plane and can be finely rotated in the θZ directions on the base member BP by driving the substrate stage drive apparatus PSTD, which includes linear motors and the like, that is controlled by the control apparatus CONT. Furthermore, the substrate stage PST is also movable in the Z axial directions, the θX directions, and the θY directions. Accordingly, the upper surface of the substrate P that is held by the substrate stage PST has six degrees of freedom and can move in the X, Y, and Z axial directions and the θX, θY, and θZ directions.

Movable mirrors 93 are each provided to a side surface of the substrate stage PST. In addition, laser interferometers 94 are provided at prescribed positions. The laser interferometers 94 use the movable mirrors 93 to measure in real time the positions of the substrate P on the substrate stage PST in the two dimensional directions as well as its rotational angles. In addition, although not shown, the exposure apparatus EX comprises a focus leveling detection system that detects surface position information of the front surface of the substrate P, which is held by the substrate stage PST. The focus leveling detection system detects the surface position information (positional information in the Z axial directions and inclination information in the θX and θY directions) of the front surface of the substrate P. The measurement results of the laser interferometers 94 are output to the control apparatus CONT. The detection results of the focus leveling detection system are also output to the control apparatus CONT. The control apparatus CONT adjusts the positional relationship between the front surface of the substrate P and the plane of the image that is formed through the projection optical system PL and the liquid LQ by driving the substrate stage drive mechanism PSTD and controlling the focus position (Z position) and the inclination angles (θX and θY) of the substrate P based on the detection results of the focus leveling detection system, and controls the position of the substrate P in the X and Y axial directions and in the θZ directions based on the measurement results of the laser interferometers 94.

The following explains the liquid immersion mechanism 1. The liquid supply apparatus 11 of the liquid immersion mechanism 1 comprises, for example, a tank that stores the liquid LQ, a pressure pump, a temperature adjusting apparatus that adjusts the temperature of the liquid LQ to be supplied, a degasifier that reduces the gas component of the liquid LQ to be supplied, and a filter unit that removes foreign matter from the liquid LQ. One end part of the supply pipe 13 is connected to the liquid supply apparatus 11 and the other end part is connected to the nozzle member 70. The control apparatus CONT controls the liquid supply operation of the liquid supply apparatus 11. The control apparatus CONT can adjust the amount of liquid that is supplied per unit of time via the supply ports 12 by controlling the liquid supply apparatus 11. Furthermore, the tank, the pressure pump, the temperature adjusting apparatus, the degasifier, the filter unit, etc. of the liquid supply apparatus 11 do not all need to be provided to the exposure apparatus EX, and they may be substituted with equipment at, for example, the plant where the exposure apparatus EX is installed.

The liquid recovery apparatus 21 of the liquid immersion mechanism 1 comprises, for example: a vacuum system such as a vacuum pump; a gas-liquid separator that separates the recovered liquid LQ and a gas; and a tank that stores the recovered liquid LQ. One end part of the recovery pipe 23 is connected to the liquid recovery apparatus 21 and the other end part is connected to the nozzle member 70. The control apparatus CONT controls the liquid recovery operation of the liquid recovery apparatus 21. The control apparatus CONT is capable of adjusting the amount of liquid that is recovered per unit of time via the recovery ports 22 by controlling the liquid recovery apparatus 21. Furthermore, the vacuum system, the gas-liquid separator, the tank, etc. of the liquid recovery apparatus 21 do not all need to be provided to the exposure apparatus EX, and they may be substituted with equipment at, for example, the plant where the exposure apparatus EX is installed.

The supply ports 12, which supply the liquid LQ, and the recovery ports 22, which recover the liquid LQ, are formed in a lower surface 70A of the nozzle member 70. The lower surface 70A of the nozzle member 70 is provided at a position that opposes the front surface of the substrate P and the upper surface 97 of the substrate stage PST. The nozzle member 70 is an annular member that is provided so that it surrounds a side surface of the last optical element LS1, and multiple supply ports 12 are provided in the lower surface 70A of the nozzle member 70 so that they surround the last optical element LS1 of the projection optical system PL (the optical axis AX of the projection optical system PL). In addition, the recovery ports 22 are provided in the lower surface 70A of the nozzle member 70 on the outer sides of the supply ports 12 (spaced apart from the supply ports 12) with respect to the last optical element LS1, and are provided so that they surround the last optical element LS1 and the supply ports 12.

Furthermore, the control apparatus CONT fills the optical path space K1 of the exposure light EL between the projection optical system PL and the substrate P with the liquid LQ so as to locally form the liquid immersion region LR of the liquid LQ on the substrate P using the liquid supply apparatus 11 to supply a prescribed amount of the liquid LQ to the optical path space K1 and the liquid recovery apparatus 21 to recover a prescribed amount of the liquid LQ from the optical path space K1. When forming the liquid immersion region LR of the liquid LQ, the control apparatus CONT drives the liquid supply apparatus 11 and the liquid recovery apparatus 21. When the liquid LQ is fed from the liquid supply apparatus 11 under the control of the control apparatus CONT, that liquid LQ flows through the supply pipe 13 and then is supplied through the supply passageway of the nozzle member 70 to the image plane side of the projection optical system PL via the supply ports 12. In addition, when the liquid recovery apparatus 21 is driven under the control of the control apparatus CONT, the liquid LQ on the image plane side of the projection optical system PL flows into the recovery passageway of the nozzle member 70 through the recovery ports 22, flows through the recovery pipe 23, and is then recovered by the liquid recovery apparatus 21.

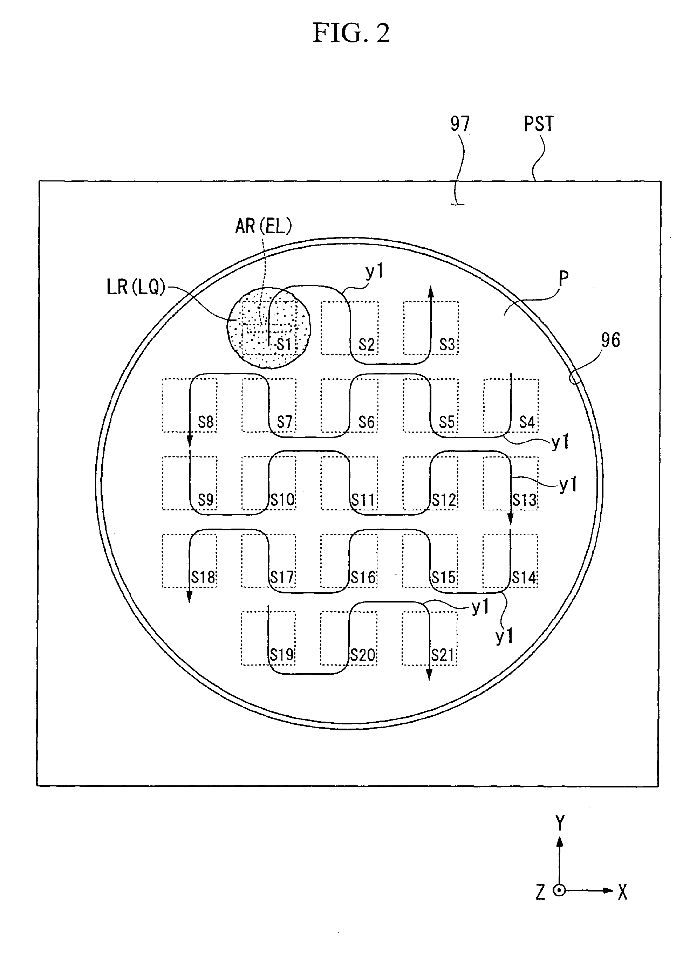

FIG. 2 is a diagram for explaining one example of the positional relationship between the immersion region LR and the substrate stage PST, which holds the substrate P, during the exposure of the substrate P. As shown in FIG. 2, a plurality of shot regions S1-S21 is set in a matrix on the substrate P. As discussed above, the exposure apparatus EX according to the present embodiment is configured so that the pattern of the mask M is projection exposed onto the substrate P while the mask M and the substrate P are moved in the Y axial directions (the scanning directions); furthermore, when each of the shot regions S1-S21 of the substrate P is exposed, the control apparatus CONT performs control such that the substrate P is irradiated with the exposure light EL via the liquid LQ of the immersion region LR while the projection area AR of the projection optical system PL moves relative to the immersion region LR, which covers the projection area AR, and the substrate P, as shown by, for example, an arrow y1 in FIG. 2. The control apparatus CONT controls the operation of the substrate stage PST so that the projection area AR (the exposure light EL) of the projection optical system PL moves along the substrate P in accordance with the arrow y1. After the exposure of one of the shot regions is complete, the control apparatus CONT steps the substrate P (substrate stage PST) so as to move the next shot region to the scanning start position; subsequently, the shot regions S1-S21 are scanned and exposed sequentially while the substrate P is moved by the step-and-scan system. In addition, in order to form the immersion region LR in a desired state, the control apparatus CONT controls the operation of the liquid immersion mechanism 1 and performs the operations of supplying and recovering the liquid LQ in parallel.

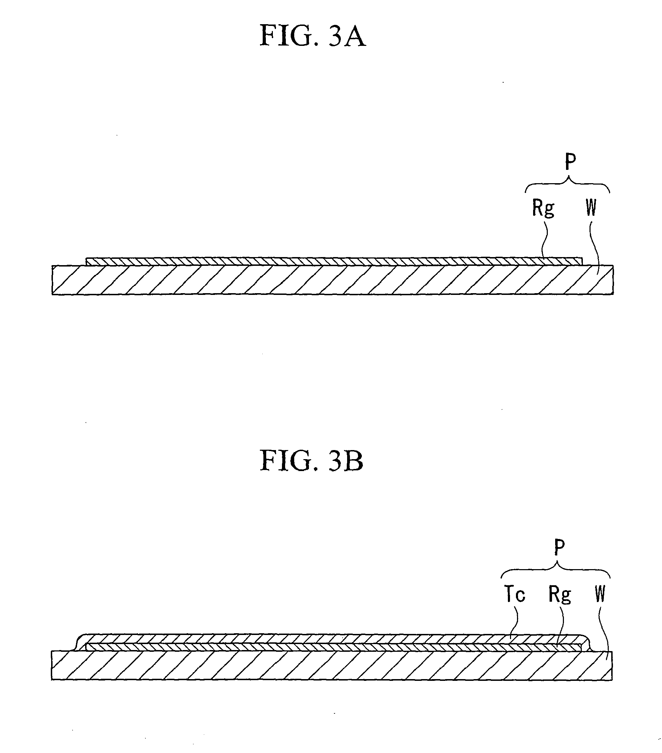

FIG. 3A and FIG. 3B are cross sectional views for explaining one example of the substrate P. The substrate P shown in FIG. 3A comprises a base material W and a first film Rg, which is formed on the upper surface of the base material W. The base material W comprises a silicon wafer. The first film Rg is formed from a photoresist (photosensitive material) and covers an area that occupies substantially the center part of the base material W upper surface with a prescribed thickness. In addition, the substrate P shown in FIG. 3B comprises a second film Tc, which covers the first film Rg front surface. The second film Tc is a protective film or an antireflection film, both of which are also called, for example, a topcoat film.

Thus, the front surface of the substrate P is formed from the first film Rg, which is made of photoresist or the like, or from the second film Tc, which is a topcoat film or the like that is provided as an upper layer of the first film Rg. Accordingly, the film that is provided to the uppermost layer of the substrate P (the front surface of the substrate P) forms a liquid contact surface that contacts the liquid LQ during the immersion exposure.

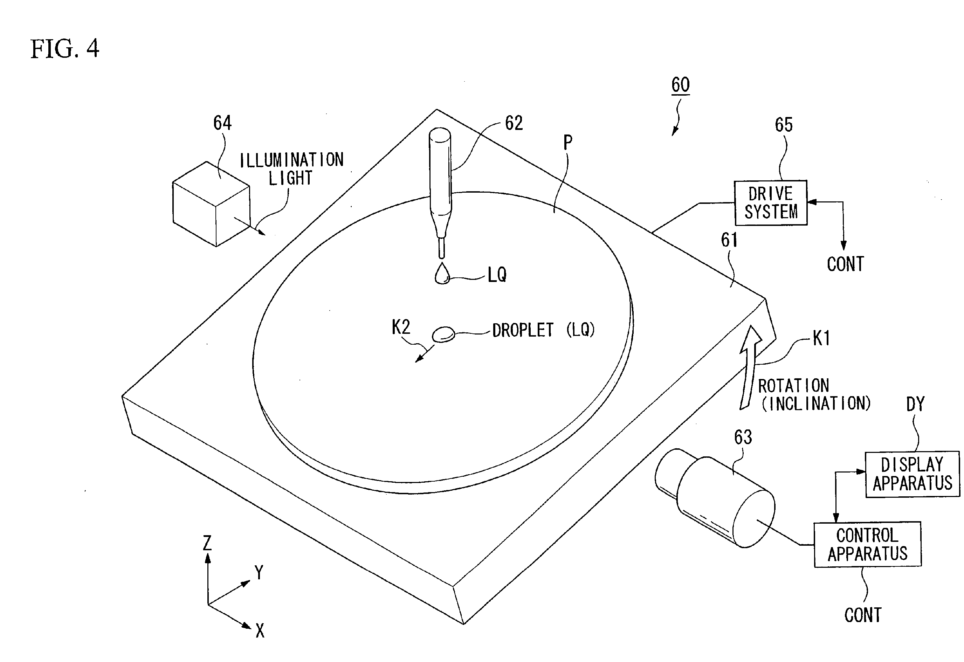

The measuring apparatus 60 will now be explained, referencing FIG. 4. In FIG. 4, the measuring apparatus 60 comprises: a holding member 61, which holds the substrate P; a drip feeding member 62, which is capable of dripping a droplet of the liquid LQ onto the front surface of the substrate P that is held by the holding member 61; an observing apparatus 63, which is capable of observing the state of the liquid LQ (droplet) on the front surface of the substrate P; and an illumination apparatus 64, which illuminates the liquid LQ (droplet) on the front surface of the substrate P.

The substrate P is loaded on the holding member 61 by the transport apparatus H, and the holding member 61 holds the substrate P that was loaded by the transport apparatus H. The transport apparatus H transports the substrate P to the holding member 61 before it undergoes the exposure process. The measuring apparatus 60 measures the substrate P before it undergoes the exposure process.

The observing apparatus 63 comprises an optical system and an imaging device, which comprises a CCD or the like. The imaging device is capable of acquiring an image (optical image) of the liquid LQ via the optical system. In the present embodiment, the observing apparatus 63 is disposed on the +X side (one side) of the substrate P, which is held by the holding member 61, and observes the state of the liquid LQ droplet on the substrate P from a position that is spaced apart from the substrate P and the holding member 61.

The illumination apparatus 64 is provided at a position that opposes the observing apparatus 63 so that the substrate P (holding member 61) is interposed therebetween. Namely, the illumination apparatus 64 is disposed on the -X side (other side) of the substrate P, which is held by the holding member 61, and illuminates the liquid LQ droplet on the substrate P from a position that is spaced apart from the substrate P and the holding member 61. Accordingly, the observing apparatus 63 acquires an image of the liquid LQ droplet that is illuminated by the illumination apparatus 64.

The observing apparatus 63 is connected to the control apparatus CONT, converts the acquired image of the liquid LQ droplet to an electrical signal, and outputs that signal (image information) to the control apparatus CONT. The control apparatus CONT is capable of displaying the image information from the observing apparatus 63 on the display apparatus DY. Accordingly, the image of the liquid LQ droplet on the front surface of the substrate P is displayed on the display apparatus DY.

The measuring apparatus 60 comprises a drive system 65, which rotates (inclines) the holding member 61 that the holds the substrate P. The control apparatus CONT controls the operation of the drive system 65, and the holding member 61 is capable of rotating (inclining) in a state wherein it holds the substrate P. In the present embodiment, the holding member 61, which holds the substrate P, is configured so that it rotates (inclines) in the $\theta X$ directions by the drive of the drive system 65.

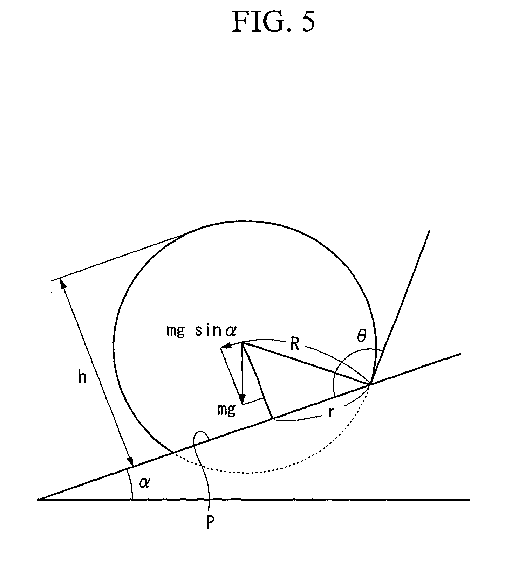

The measuring apparatus 60 is capable of measuring: an adhesive force (adhesive energy) "$E$", which acts between the liquid LQ and the front surface of the substrate P; a static contact angle "$\theta$" of the liquid LQ on the front surface of the substrate P; and a sliding angle "$\alpha$" of the liquid LQ on the front surface of the substrate P. The adhesive force (adhesive energy) "$E$" is the force that is needed in order to move the liquid on the front surface of the object (herein, the front surface of the substrate P). The adhesive force "$E$" will now be explained, referencing FIG. 5.

In FIG. 5, if we assume that the external form of the droplet on the substrate P is a partial circle, i.e., if we assume that the surface of the droplet on the substrate P in FIG. 5 is an ideal spherical surface, then the adhesive force "$E$" is defined by,

$$E = (m \times g \times \sin \alpha)/(2 \times \pi \times R) \qquad ...(1)$$

where "$m$" is the mass of the liquid LQ droplet on the substrate P, "$g$" is the gravitational acceleration, "$\alpha$" is the sliding angle with respect to the horizontal plane, and "$R$" is the radius of the liquid LQ droplet on the substrate P.

When the front surface of the object is inclined with respect to the horizontal plane in a state wherein the liquid LQ droplet is adhered to the object front surface (herein, the front surface of the substrate P), the sliding angle "$\alpha$" is the angle at which the liquid LQ droplet, which is adhered to the front surface of the object, begins to slide (starts to move) downward as a result of the action of gravity. In other words, when the front surface of the object, to which the liquid droplet is adhered, is inclined, the sliding angle "$\alpha$" is the critical angle at which the droplet slides downward.

In addition, in FIG. 5, "$\theta$" indicates the static contact angle of the liquid LQ on the front surface of the substrate P. The contact angle "$\theta$" is the angle (as taken from the interior of the liquid) that is formed between the surface of the droplet and the front surface of the object in a state wherein the liquid droplet is adhered to the front surface of the object (herein, the front surface of the substrate P) and is stationary.

As discussed above, it is assumed that the external form of the droplet is a partial circle and, in FIG. 5, the contact angle of the liquid LQ on the inclined surface is indicated by "$\theta$"; however, the contact angle "$\theta$" herein is the contact angle in a plane that is parallel to the horizontal plane. In addition, the drip feeding member 62 is capable of adjusting a mass (or volume) "$m$" of the droplet that is dripped and, if that mass (or volume) "$m$" is known, then it is possible to measure the contact angle "$\theta$" and to derive the radius "$R$" geometrically based thereon. Furthermore, if the contact angle "$\theta$" is known, then it is also possible to derive geometrically a radius "r" of the contact surface between the droplet and the front surface of the substrate P (hereinbelow, appropriately called the "adhered liquid radius "$r$""). Likewise, if the contact angle "$\theta$" is known, then it is also possible to derive a height "$h$" of the droplet with respect to the front surface of the substrate P. Namely, the radius "$R$" of the liquid LQ droplet on the front surface of the substrate P is a value that is in accordance with the contact angle "$\theta$" of the liquid LQ, and it is possible to derive the radius "$R$" in equation (1), which was discussed above, by deriving the contact angle "$\theta$" of the liquid LQ.

As was explained referencing FIG. 3A and FIG. 3B, the films (the first film Rg and the second film Tc) that are provided to the uppermost layer of the substrate P form the liquid contact surface that contacts the liquid LQ during immersion exposure; however, the contact angle "$\theta$" and the sliding angle "$\alpha$" discussed above vary with the type (physical properties) of film. The measuring apparatus 60 can measure the contact angle "$\theta$" and the sliding angle "$\alpha$" and can derive the adhesive force "$E$" for each substrate P.

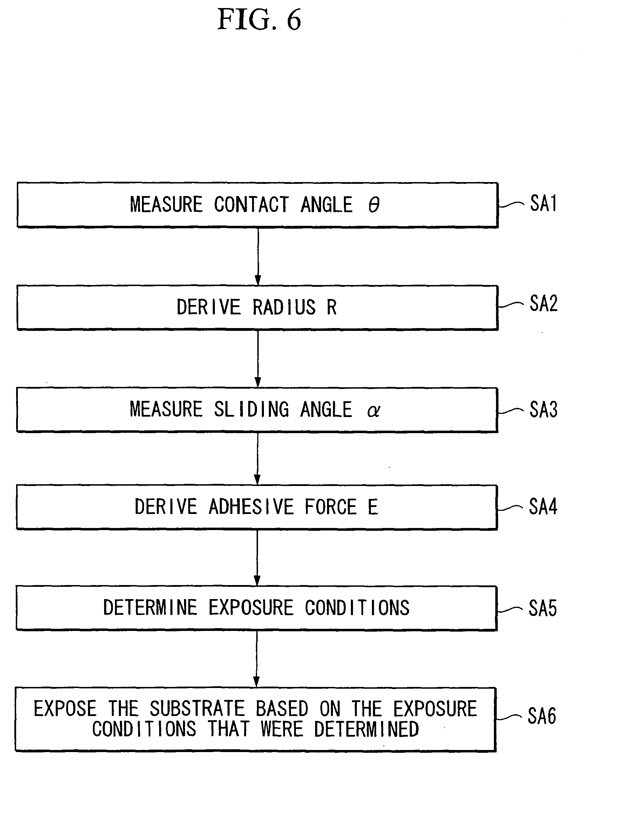

One example of a measurement procedure that uses the measuring apparatus 60 and an exposure procedure for exposing the substrate P will now be explained, referencing the flow chart diagram in FIG. 6.

When the substrate P (before it has undergone the exposure process) is loaded onto the holding member 61 of the measuring apparatus 60 by the transport apparatus H, the control apparatus CONT starts the measurement operation wherein the measuring apparatus 60 is used. First, the measuring apparatus 60 measures the static contact angle "$\theta$" of the liquid LQ on the front surface of the substrate P (step SA1). When the static contact angle "$\theta$" of the liquid LQ on the front surface of the substrate P is measured, the measuring apparatus 60 uses the drive system 65 to adjust the position (the attitude) of the holding member 61 so that the front surface of the substrate P, which is held by the holding member 61, is substantially parallel to the horizontal plane (XY plane). Furthermore, the measuring apparatus 60 uses the drip feeding member 62 to drip a liquid LQ droplet onto the front surface of the substrate P, which is substantially parallel to the horizontal plane. The drip feeding member 62 is capable of adjusting the mass (or volume) "$m$" of the droplet to be dripped, and drips a droplet of mass m" on the front surface of the substrate P. After the droplet of mass "$m$" is disposed on the front surface of the substrate P, the measuring apparatus 60 uses the illumination apparatus 64 to illuminate the droplet, which is disposed on the front surface of the substrate P, and uses the observing apparatus 63 to acquire a droplet image. The observing apparatus 63 outputs image information, which relates to the acquired image, to the control apparatus CONT. Based on the signal (image information) output by the observing apparatus 63, the control apparatus CONT displays the image of droplet, which is on the front surface of the substrate P, on the display apparatus DY. In addition, the control apparatus CONT performs arithmetic processing (image processing) on the signal that is output by the observing apparatus 63 and, based on that process result, derives the contact angle "$\theta$" of the liquid LQ droplet on the front surface of the substrate P. In so doing, the measuring apparatus 60, which includes the control apparatus CONT, measures the static contact angle "$\theta$" of the liquid LQ on the front surface of the substrate P.

In addition, the measuring apparatus 60, which includes the control apparatus CONT, derives the radius "$R$" of the liquid LQ droplet on the substrate P (step SA2). As discussed above, because the drip feeding member 62 is capable of adjusting the mass "$m$" of the droplet to be dripped and because the radius "$R$" can be derived geometrically, the measuring apparatus 60, which includes the control apparatus CONT, can derive the radius "R" of the liquid LQ droplet on the substrate P by performing a prescribed arithmetic process based on the mass "$m$" of the droplet, which is a known value, and the contact angle "θ", which is the measurement result.

Furthermore, it was explained that the drip feeding member 62 is capable of adjusting the mass "$m$" of the droplet to be dripped; however, if a density (specific gravity) "$\rho$" of the liquid LQ is known and the drip feeding member 62 is capable of adjusting a volume "$V$" of the droplet to be dripped, then it is possible to derive the mass "$m$" based on the density "$\rho$" and the volume "$V$" ($m = \rho \times V$).

Next, the measuring apparatus 60 measures the sliding angle "$\alpha$" of the liquid LQ on the front surface of the substrate P (step SA3). When the sliding angle "$\alpha$" of the liquid LQ on the front surface of the substrate P is measured, the measuring apparatus 60 uses the drive system 65 to rotate (incline) the holding member 61, which holds the substrate P in a state wherein the droplet of mass "$m$" is disposed on the front surface of the substrate P, in the θX directions, as shown by an arrow K1 in FIG. 4. As the holding member 61 rotates (inclines), the front surface of the substrate P also rotates (inclines). While the substrate P rotates, the observing apparatus 63 continues to observe the droplet that is disposed on the front surface of the substrate P. As the substrate P rotates, the droplet adhered to the front surface of the substrate P begins to slide (begins to move) as a result of the action of gravity, as shown by an arrow K2 in FIG. 4. The observing apparatus 63 is capable of observing the fact that the droplet begins to slide, and outputs image information related to the acquired image to the control apparatus CONT. Namely, based on the signal (image information) that was output by the observing apparatus 63, the control apparatus CONT can derive the point in time that the droplet on the front surface of the substrate P begins to move (the point in time that it begins to slide). In addition, based on a drive quantity (degree of inclination) with which the drive system 65 drives the holding member 61, the control apparatus CONT can derive the angle (i.e., the sliding angle) "$\alpha$" of the front surface of the substrate P at the point in time that the droplet on the front surface of the substrate P begins to move. Namely, the control apparatus CONT can derive the signal (image information) that is output by the observing apparatus 63 and, based on the drive quantity with which the drive system 65 drives the holding member 61, the sliding angle "$\alpha$" of the liquid LQ droplet on the front surface of the substrate P. Thus, the measuring apparatus 60, which includes the control apparatus CONT, measures the sliding angle "$\alpha$" of the liquid LQ on the front surface of the substrate P.

Furthermore, the state of the droplet may be displayed on the display apparatus DY and the angle (i.e., the sliding angle) "$\alpha$" of the front surface of the substrate P at the point in time that the droplet on the front surface of the substrate P begins to move may be measured visually.

Next, the measuring apparatus 60 derives the adhesive force "$E$" that acts between the substrate P and the liquid LQ (step SA4). Based on the steps SA1-SA3 that were discussed above, the mass "$m$" of the liquid LQ droplet on the substrate P, the radius "R" of the liquid LQ droplet on the substrate P, and the sliding angle "$\alpha$" are derived, and it is consequently possible to derive the adhesive force (adhesive energy) "$E$" that acts between the liquid LQ and the front surface of the substrate P by substituting these values in the abovementioned equation (1).

As discussed above, the radius "$R$" of the liquid LQ droplet on the substrate P is a value that is in accord with the contact angle "θ" of the liquid LQ; consequently, the adhesive force "$E$" is a value that is prescribed in accordance with the contact angle "θ" of the liquid LQ on the front surface of the substrate P and the sliding angle "$\alpha$" of the liquid LQ on the front surface of the substrate P.

Furthermore, when the contact angle "θ" and the sliding angle "$\alpha$" are measured in the steps SA1-SA3 discussed above, the operation of measuring such is performed multiple times while the mass (or volume) "$m$" of the droplet is varied, and the adhesive force "$E$" may be derived by using the average values of the contact angles "θ", the radii "R", and the sliding angles "$\alpha$" obtained by these measurement operations.

Next, based on the measurement results of the measuring apparatus 60, the control apparatus CONT determines the exposure conditions to be used during the exposure of the substrate P (step SA5). Namely, the control apparatus CONT determines, in accordance with the adhesive force "$E$" that acts between the liquid LQ and the front surface of the substrate P and that was derived in step SA4, the exposure conditions to be used during the exposure of the substrate P. As discussed above, because the adhesive force "$E$" is prescribed in accordance with the static contact angle "θ" of the liquid LQ on the front surface of the substrate P and the sliding angle "$\alpha$" of the liquid LQ on the front surface of the substrate P, the control apparatus CONT therefore determines the exposure conditions to be used during the exposure of the substrate P based on the static contact angle "θ" of the liquid LQ on the front surface of the substrate P, which is the result of the measurement that was made in step SA1, and on the sliding angle "$\alpha$" of the liquid LQ on the front surface of the substrate P, which is the result of the measurement that was made in step SA3.

Here, the exposure conditions include at least one of the movement conditions to be used when the substrate P is moved and the liquid immersion conditions to be used when the immersion region LR is formed.

The movement conditions of the substrate P include at least one of the substrate P movement speed, acceleration, deceleration, movement direction, and distance of continuous movement in one direction.

In addition, the liquid immersion conditions include at least one of supply conditions to be used when the liquid LQ is supplied in order to form the immersion region LR and recovery conditions to be used when the liquid LQ that forms the immersion region LR is recovered. The supply conditions include the quantity of liquid that is supplied per unit of time to the optical path space K1 via the supply ports 12. The recovery conditions include the quantity of liquid that is recovered per unit of time via the recovery ports 22.

Furthermore, the exposure conditions are applicable not only during exposure when each of the shot regions on the substrate P is irradiated with the exposure light EL, but also before and after the exposure of each of the shot regions.

In addition, if there is a possibility that the optical characteristics of the projection optical system PL will fluctuate as a result of variations in the pressure of the liquid LQ that are in accordance with, for example, the static contact angle "θ" between the liquid LQ and the film on the front surface of the substrate P, which in turn cause fluctuations in the projection optical system PL (last optical element LS1), then the adjustment conditions of the projection optical system PL that are needed in order to compensate for such fluctuations in optical characteristics are stored in the storage apparatus MRY as exposure conditions.

Information that relates to optimum exposure conditions that correspond to the adhesive force "$E$" is stored in the storage apparatus MRY in advance. Specifically, the storage apparatus MRY stores the relationship between the adhesive force "$E$", which acts between the liquid LQ and the film that is formed on the liquid contact surface that contacts the liquid LQ on the substrate P during immersion exposure, and the optimum exposure conditions that correspond to that adhesive force "$E$" as map data. The information (map data) related to the optimum exposure conditions that correspond to the adhesive force "$E$" can be derived in advance either empirically or by simulation, and is stored in the storage apparatus MRY.

To simplify the explanation, in the present embodiment, information related to the optimal movement speed of the substrate P that corresponds to the adhesive force "$E$" and information related to the optimal liquid supply quantity per unit of time that corresponds to the adhesive force "$E$" are stored in the storage apparatus MRY as the optimum exposure conditions that correspond to the adhesive force "$E$".

The control apparatus CONT determines the exposure conditions to be used during the exposure of the substrate P based on the measurement results of the measuring apparatus 60 and the information that is stored in the storage apparatus MRY. Namely, based on the adhesive force "$E$", which acts between the liquid LQ and the front surface of the substrate P and that was derived in step SA4, and on the information (map data) related to the optimum exposure conditions that correspond to the adhesive force "$E$" and are stored in the storage apparatus MRY in advance, the control apparatus CONT determines the optimum exposure conditions by selecting such from the information (map data) that is stored in the storage apparatus MRY for the substrate P that is to undergo the exposure process.

In the present embodiment, the control apparatus CONT determines, in accordance with the adhesive force "$E$", the movement speed of the substrate P and the quantity of liquid supplied per unit of time to the optical path space K1 by the liquid immersion mechanism 1.

Furthermore, the control apparatus CONT uses the transport apparatus H to load the substrate P, for which measurements have been completed by the measuring apparatus 60, to the substrate stage PST and, based on the exposure conditions that were determined in step SA5, performs an immersion exposure of the substrate P (step SA6).

In the present embodiment, the control apparatus CONT exposes each of the shot regions on the substrate P while adjusting the quantity of liquid supplied per unit of time to the optical path space K1 by the liquid immersion mechanism 1 and the movement speed of the substrate P based on the exposure conditions determined in step SA5.

For example, if the adhesive force "$E$" that acts between the liquid LQ on the front surface of the substrate P that is to undergo the exposure process is large and the movement speed of the substrate P increases, then there is a possibility that it will be difficult to fill the optical path space K1 with the liquid LQ satisfactorily, and consequently the control apparatus CONT decreases the movement speed of the substrate P in accordance with the adhesive force "$E$". In so doing, it is possible to expose the substrate P in a state wherein the optical path space K1 is filled with the liquid LQ satisfactorily. Moreover, if the adhesive force "$E$" is small, then the movement speed of the substrate P can be increased, which makes it possible to improve throughput.

Herein, the movement speed of the substrate P includes, of course, the movement speed in the Y axial directions (the scanning directions) as well as the movement speed in the X axial directions (the stepping directions).

In addition, the control apparatus CONT adjusts the quantity of liquid that is supplied per unit of time to the optical path space K1 by controlling the operation of the liquid immersion mechanism 1 based on the determined exposure conditions. For example, if the adhesive force "$E$" that acts between the liquid LQ and the front surface of the substrate P that is to undergo the exposure process is small, then bubbles will likely form in the liquid LQ. Accordingly, if the adhesive force "$E$" is small, then the control apparatus CONT increases the quantity of liquid that is supplied per unit of time to the optical path space K1 in accordance with the adhesive force E so as to supply a large amount of degasified liquid LQ to the optical path space K1 via the supply ports 12. In so doing, even if bubbles are present in the liquid LQ of the optical path space K1, those bubbles can be eliminated or reduced in number by dissolving them in the degasified liquid LQ. Accordingly, the substrate P can be exposed in a state wherein the optical path space K1 is filled with the liquid LQ in a desired state.

In addition, even if we assume that bubbles are generated in the optical path space K1, those bubbles can be removed from the optical path space K1 immediately by supplying large amounts of the liquid LQ. Moreover, if the adhesive force "$E$" is large, then the quantity of liquid that is supplied per unit of time to the optical path space K1 can be reduced, which makes it possible to reduce the amount of the liquid LQ that is used.

As explained above, the exposure conditions to be used during the exposure of the substrate P are determined in accordance with the adhesive force "$E$" that acts between the liquid LQ and the front surface of the substrate P, and therefore it is possible to perform an immersion exposure on each of multiple substrates P, whereon different types of film are formed, satisfactorily. Accordingly, it is possible to improve the versatility of the immersion exposure apparatus EX.

Furthermore, as discussed above, it is possible to include, for example, the acceleration and deceleration of the substrate P during movement as well as the direction of that movement (the movement trajectory) with respect to the optical path space K1 in the movement conditions of the substrate P. Based on the adhesive force "$E$", the control apparatus CONT determines the acceleration and deceleration and the movement direction (movement trajectory), and performs an immersion exposure of the substrate P while controlling the operation of the substrate stage PST based on the determined acceleration and deceleration and movement direction (movement trajectory). In this case as well, the storage apparatus MRY stores information in advance related to, for example, the optimal acceleration and the movement direction (movement trajectory) that corresponds to the adhesive force "$E$", and the control apparatus CONT therefore can determine the optimal acceleration and the movement direction (movement trajectory) to be used during the exposure of the substrate P based on the adhesive force "$E$" and the information that is stored in the storage apparatus MRY. For example, if the adhesive force "$E$" is large and the acceleration of the substrate P increases, then there is a possibility that it will be difficult to fill the optical path space K1 with the liquid LQ satisfactorily, and consequently the acceleration of the substrate P is decreased. Moreover, if the adhesive force "$E$" is small, then the acceleration of the substrate P can be increased.

In addition, the supply conditions discussed above can also include, for example, a liquid supply position (distance) with respect to the optical path space K1 as well as a supply direction. Namely, the supply conditions can include, for example, the positions and the distances of the supply ports 12 with respect to the optical path space K1, as well as the number of the supply ports 12. Based on the adhesive force "$E$", the control apparatus CONT determines these supply conditions and can perform an immersion exposure of the substrate P while controlling the operation of the liquid immersion mechanism 1 based on these determined supply conditions. In this case as well, the storage apparatus MRY stores information in advance related to the optimal supply position (distance) and the supply direction that correspond to the adhesive force "$E$", and the control apparatus CONT therefore can determine the optimal supply conditions to be used during the exposure of the substrate P based on the adhesive force "$E$" and the information that is stored in the storage apparatus MRY. Based on the adhesive force "$E$", the control apparatus CONT adjusts the supply conditions to be used when supplying the liquid LQ, and therefore can supply the liquid LQ satisfactorily and form the immersion region LR in a desired state.

In addition, as discussed above, the liquid immersion conditions include the recovery conditions to be used during the recovery of the liquid LQ from the optical path space K1. The recovery conditions can include not only the quantity of liquid that is recovered per unit of time from the optical path space K1, but also a liquid recovery position (distance) with respect to the optical path space K1 and a recovery direction. Namely, the recovery conditions can include, for example, the recovery force (suction force) of the liquid recovery apparatus 21, the positions and the distances of the recovery ports 22 with respect to the optical path space K1, as well as the number of the recovery ports 22. The control apparatus CONT determines these recovery conditions based on the adhesive force "$E$", and can perform an immersion exposure of the substrate P while controlling the operation of the liquid immersion mechanism 1 based on those determined recovery conditions. In this case as well, the storage apparatus MRY stores information in advance that relates to, for example, the optimal liquid recovery quantity per unit of time that corresponds to the adhesive force "$E$", the recovery position (distance), and the recovery direction, and therefore the control apparatus CONT can determine, based on the adhesive force "$E$" and the information that is stored in the storage apparatus MRY, the optimal recovery conditions to be used during the exposure of the substrate P. There is a possibility that the liquid LQ recoverability (recovery capacity) of the liquid immersion mechanism 1 during the recovery of the liquid LQ will fluctuate in accordance with the adhesive force "$E$", but the control apparatus CONT adjusts the recovery conditions to be used during the recovery of the liquid LQ in accordance with the adhesive force "$E$", which makes it possible to recover the liquid LQ satisfactorily and to form the immersion region LR in the desired state.

Furthermore, with regard to the conditions that are stored in the storage apparatus MRY in the present embodiment, it is understood that the movement conditions of the substrate P and the liquid immersion conditions are optimized. For example, if the movement speed of the substrate P is high, then the optical path space K1 can be filled with the liquid LQ satisfactorily by increasing the liquid supply quantity per unit of time and recovering the liquid LQ at a liquid recovery rate that is in accordance with that liquid supply rate. Moreover, if the movement speed of the substrate P is relatively low, then the liquid supply quantity per unit of time can be decreased.

Furthermore, in the embodiment discussed above, the static contact angle "$\theta$" of the liquid LQ on the front surface of the substrate P and the sliding angle "$\alpha$" of the liquid LQ on the front surface of the substrate P are measured by a single measuring apparatus 60; however, a first measuring apparatus that measures the static contact angle "$\theta$" of the liquid LQ on the front surface of the substrate P and a second measuring apparatus that measures the sliding angle "α" of the liquid LQ on the front surface of the substrate P may be provided separately.

In addition, in the embodiment discussed above, the measuring apparatus 60 is provided along the transport pathway of the transport apparatus H; however, the measuring apparatus 60 may be installed at a position that is not along the transport pathway of the transport apparatus H.

In addition, in the embodiment discussed above, each of the substrates P is measured by the measuring apparatus 60; however, if the film that is formed on the front surface is the same as that of a previously measured substrate P, then the measurement performed by the measuring apparatus 60 may be omitted. For example, the measuring apparatus 60 may measure only one substrate P that is at the head of lot that comprises a plurality of substrates P.

In addition, in the embodiment discussed above, based on the results of the measurements made by the measuring apparatus 60, the exposure conditions are determined for the substrate P after those measurements have been made; however, the exposure conditions may be determined for each of the shot regions on the substrate P after those measurements have been made.

Furthermore, in the embodiment discussed above, pure water is used as the liquid LQ, the adhesive force "$E$" of the substrate P with respect to the liquid LQ is derived, and the exposure conditions to be used during the exposure of the substrate P are determined in accordance with that adhesive force "$E$"; however, the adhesive force "$E$" may be set to a desired value by changing the type (physical properties) of the liquid LQ, e.g., by using fluorine based oil as the liquid LQ. In addition, the exposure conditions may be determined in accordance with that adhesive force "$E$". Alternatively, the physical properties of the liquid LQ (pure water) may be modified by adding a prescribed material (additive) thereto.

Furthermore, the first embodiment discussed above explained that the liquid LQ droplet is disposed on the front surface of the substrate P that is actually to be exposed in order to fabricate a device, and that the state of the droplet when that substrate P is inclined is measured by the measuring apparatus 60; however, for example, the droplet may be disposed on an object (e.g., a test substrate) that has a front surface that is substantially the same as the front surface of the substrate P that is actually to be exposed, and the state of the droplet when the front surface of that object is inclined may be measured.

<Second Embodiment>

The following explains the second embodiment. In the explanation below, constituent parts that are identical or equivalent to those in the embodiment discussed above are assigned identical symbols, and the explanations thereof are therefore abbreviated or omitted.

In the embodiment discussed above, the exposure conditions to be used during the exposure of the substrate P are determined (adjusted) in accordance with the adhesive force "$E$" between the liquid LQ (pure water) and the substrate P that is to undergo the exposure process; however, the permissible range of the adhesive force "$E$" may be determined and, prior to the exposure of the substrate P, it may be determined whether that substrate P has a film for which the adhesive force "$E$" with respect to the liquid LQ (pure water) is within the permissible range, i.e., whether it is a substrate P that has a film that is appropriate for the immersion exposure process. For example, an indicator value (permissible value) for determining whether the adhesive force "$E$" is appropriate for the immersion exposure process can be stored in the storage apparatus MRY in advance and it can be determined whether the adhesive force "$E$" is appropriate for the immersion exposure process based on this indicator value. The indicator value can be derived in advance, for example, empirically or by simulation. Furthermore, based on the determination results discussed above, it is possible to make it so that a substrate P that has an inappropriate film does not undergo the exposure process. For example, if the measuring apparatus 60 measures the adhesive force "$E$" with respect to the liquid LQ (pure water) on the substrate P that is transported by the transport apparatus H, and it is found that the measured adhesive force "$E$" falls outside of the prescribed permissible range, then that substrate P is not loaded on the substrate stage PST. In so doing, the substrate P that has a film that is inappropriate for the immersion exposure is not exposed needlessly, which prevents leakage of the liquid LQ or the like and can contribute to the improvement of the operating ratio of the exposure apparatus EX.

In addition, in the present embodiment as well, the type (physical properties) of the liquid LQ may be changed so that the adhesive force "$E$" that acts between the liquid LQ and the front surface of the substrate P falls within the permissible range. Alternatively, the adhesive force "$E$" that acts between the liquid LQ and the front surface of the substrate P may be made to fall within the permissible range by adding a prescribed material (additive) to the liquid LQ (pure water).

<Third Embodiment>

The following explains the third embodiment. In the first and second embodiments discussed above, the measuring apparatus 60 in the exposure apparatus EX measures the static contact angle "θ" of the liquid LQ on the front surface of the substrate P and the sliding angle "α" of the liquid LQ on the front surface of the substrate P; however, it is possible for an apparatus that is separate from the exposure apparatus EX to measure the static contact angle "θ" and the sliding angle "α" without installing the measuring apparatus 60 inside the exposure apparatus EX. In the present embodiment, the information regarding the static contact angle "θ" of the liquid LQ on the front surface of the substrate P and the information regarding the sliding angle "α" of the liquid LQ on the front surface of the substrate P are input to the control apparatus CONT via the input apparatus INP in order to determine the exposure conditions to be used during the exposure of the substrate P. The control apparatus CONT determines the exposure conditions to be used during the exposure of the substrate P based on the information regarding the contact angle "θ" and the information regarding the sliding angle "α", which are input from the input apparatus INP. Namely, similar to the embodiments discussed above, the control apparatus CONT derives the adhesive force "$E$" based on the information regarding the contact angle "θ" and the information regarding the sliding angle "α" that were input from the input apparatus INP, and determines the optimum exposure conditions for the substrate P that is to undergo the exposure process based on that derived adhesive force "$E$" and on the information (map data) that relates to the optimum exposure conditions that correspond to the adhesive force "$E$" and that are stored in the storage apparatus MRY in advance.

Furthermore, the data that is input by the input apparatus INP may be the adhesive force "$E$" that was derived based on the measured static contact angle "θ" and the sliding angle "α". Alternatively, instead of performing measurements, the data that is input by the input apparatus INP may be known values of physical properties (the static contact angle "θ" and the sliding angle "α", or the adhesive force "$E$").

In addition, in the first through third embodiments discussed above, the storage apparatus MRY stores the relationship between the optimum exposure conditions and the adhesive force (static contact angle and sliding angle); however, the optimal exposure conditions that correspond to the adhesive force "$E$" may be derived by storing a function that is determined empirically or by simulation in the storage apparatus MRY, and then using that function.

<Fourth Embodiment>

The fourth embodiment will now be explained. In the first through third embodiments discussed above, the adhesive force "$E$" is derived based on the static contact angle "θ" of the liquid LQ on the front surface of the substrate P and the sliding angle "α" of the liquid LQ on the front surface of the substrate P, and the exposure conditions to be used during the exposure of the substrate P are determined in accordance with that adhesive force "$E$"; however, the characteristic feature of the present embodiment lies in the fact that the exposure conditions to be used during the exposure of the substrate P are determined based on an equation ($\theta - t \times \alpha$).

In the present embodiment, the control apparatus CONT determines the exposure conditions to be used during the exposure of the substrate P based on a value "$U$" that is defined by following equation (2):

$$U = (\theta - t \times \alpha) \text{ ...(2)}$$

where "θ" is the static contact angle of the liquid LQ on the front surface of the substrate P, "α" is the sliding angle of the liquid LQ on the front surface of the substrate P, and "$t$" is the prescribed constant.

The present inventor found that the exposure conditions (movement conditions of the substrate P, liquid immersion conditions, and the like), wherein the immersion region LR on the substrate P can be maintained in a desired state, vary with the value "$U$" ($\theta - t \times \alpha$). Namely, when the optical path space K1 between the film of the substrate P and the last optical element LS1 of the exposure apparatus EX is filled with the liquid LQ and the immersion region LR of the liquid LQ is formed on the substrate P, it was found that the exposure conditions, wherein the immersion region LR can be maintained in the desired state, vary with the value "$U$" that corresponds to the liquid LQ and the film of the substrate P. Accordingly, setting the optimal exposure conditions in accordance with the value "$U$" makes it possible to expose the substrate P without the occurrence of problems such as the liquid LQ flowing out and the generation of bubbles in the liquid LQ.

For example, the exposure conditions discussed above include the movement conditions of the substrate P. Namely, when the substrate P (film) is moved in a state wherein the optical path space K1 between the film of the substrate P and the last optical element LS 1 of the exposure apparatus EX is filled with the liquid LQ and the immersion region LR of the liquid LQ is formed on the film, the maximum speed (hereinbelow, called the permissible speed) at which the immersion region LR can be maintained in the desired state varies with the value "$U$" that corresponds to the liquid LQ and the film of the substrate P. Accordingly, if the substrate P is moved at a speed that is less than the permissible speed that corresponds to the value "$U$", then it is possible to expose the substrate P while suppressing the occurrence of problems such as the liquid LQ flowing out and the generation of bubbles in the liquid LQ.

In the present embodiment, the control apparatus CONT determines the movement conditions to be used during the movement of the substrate P (the substrate P movement speed) based on the value "$U$" discussed above.

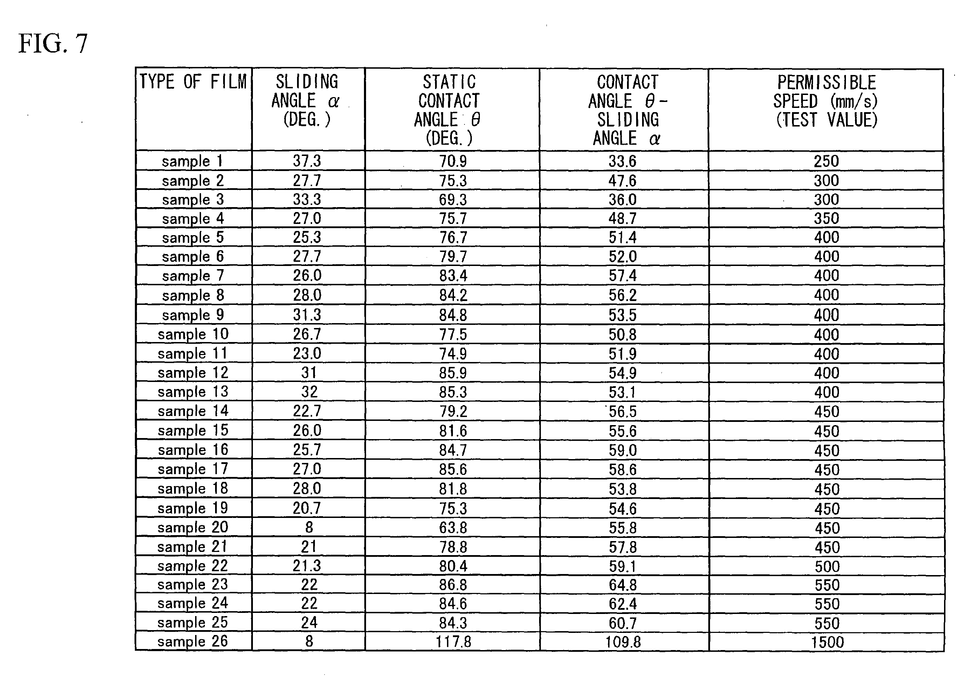

FIG 7 shows one example of the results of a test that was conducted in order to derive the relationship between the value "*U*" and the permissible speed. The test varied the type of the film provided to the uppermost layer of the substrate P (the front surface of the substrate P), measured the static contact angle "θ" of the liquid LQ and the sliding angle "α" of the liquid LQ on each film of the plurality of film types, and derived the value "*U*" and the permissible speed of the substrate P for each of the films. Furthermore, the permissible speeds of the substrate P shown in the test example in FIG. 7 are the speeds at which the substrate P can be moved while the optical path space K1 is filled with the liquid LQ without that liquid LQ flowing out (without leaving behind any drop or film of the liquid LQ on the substrate P). In addition, as shown in FIG. 7, 26 types of film were prepared for the present test example, and data were obtained for each of the films.

As discussed above, the measuring apparatus 60 is capable of measuring the static contact angle "θ" of the liquid LQ on the front surface of the substrate P and the sliding angle "α" of the liquid LQ on the front surface of the substrate P; therefore, in the present test example, a prescribed amount (e.g., 50 μl) of the liquid LQ was dripped onto the front surface of each film, and the measuring apparatus 60 was used to derive the static contact angle "θ" of the liquid LQ and the sliding angle "α" for each film. In addition, a prescribed constant "*t*" is a value that is prescribed in accordance with, for example, the structure and the performance (for example, the liquid supply capacity and the liquid recovery capacity) of the nozzle member 70, and can be derived either empirically or by simulation.

Furthermore, in the present test example, the prescribed constant "*t*" is 1 and, based on the measurement results of the measuring apparatus 60, the value "*U*" (i.e., θ - α) and the permissible speed are derived for each film. As discussed above, the film on the substrate P forms the liquid contact surface that contacts the liquid LQ during the immersion exposure, and consequently the permissible speed varies in accordance with the type (physical properties) of the film, i.e., in accordance with the value "*U*", as shown in FIG. 7.

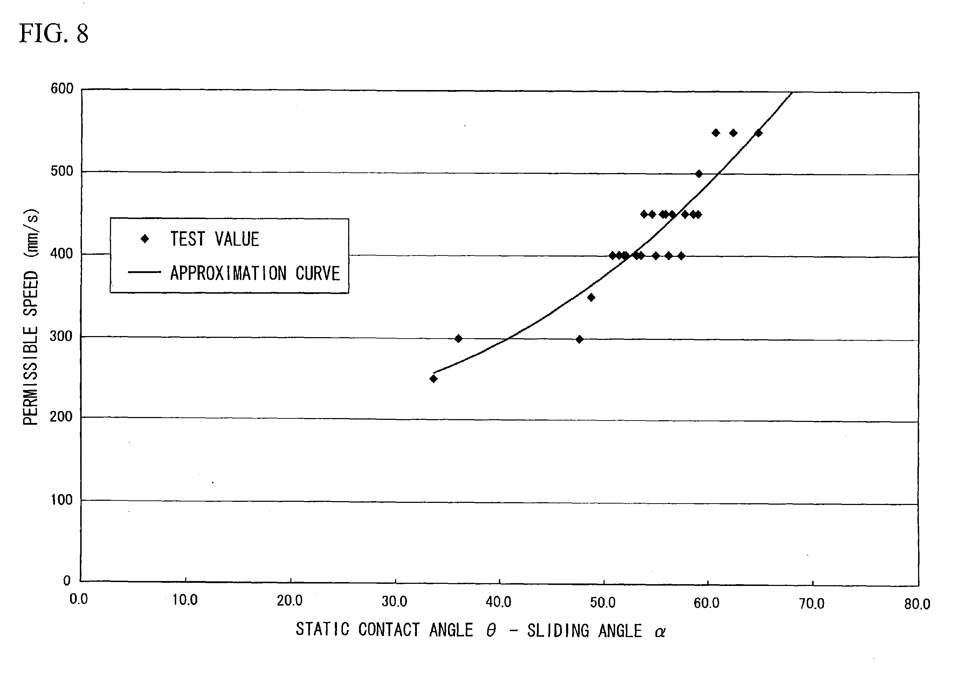

FIG. 8 shows the relationship between the value "*U*" (wherein "*t*" = 1) and the permissible speed, i.e., it graphs the test results in FIG. 7. FIG. 8 shows the data points that correspond to the test results discussed above, as well as an approximation curve that fits those test results. As shown in FIG. 8, it can be seen that the permissible speed varies with the value "*U*" (θ-*t* × α). Specifically, it can be seen that the greater the value "*U*" becomes, the greater the permissible speed becomes. Accordingly, the provision of a film with a large value "*U*" on the substrate P makes it possible to expose that substrate P while moving it at high speed in a state wherein the space between the last optical element LS1 and the substrate P (film) is filled with the liquid LQ.

One example of a measurement procedure that uses the measuring apparatus 60 and an exposure procedure that is used during the exposure of the substrate P will now be explained. During the exposure of the substrate P that has a prescribed film, the control apparatus CONT uses the measuring apparatus 60 to measure, prior to exposing that substrate P, the static contact angle "θ" of the liquid LQ on the front surface (film) of the substrate P. In addition, the control apparatus CONT uses the measuring apparatus 60 to measure the sliding angle "α" of the liquid LQ on the front surface (film) of the substrate P. Furthermore, the control apparatus CONT derives the value "*U*" (θ - *t* × α) based on the measurement results of the measuring apparatus 60. The storage apparatus MRY stores information (function, map data, and the like) in advance for deriving the permissible speed of the substrate P that corresponds to the value "*U*" (static contact angle "θ" and sliding angle "α"). In the present embodiment, the storage apparatus MRY stores, as a value "*U*" parameter, a function (e.g., a function that corresponds to the approximation curve in FIG. 8) that derives the permissible speed of the substrate P that corresponds to the value "*U*". As discussed above, the information that relates to the permissible speed of the substrate P that corresponds to the value "*U*" can be derived in advance either empirically or by simulation, and is stored in the storage apparatus MRY.

The control apparatus CONT determines the exposure conditions (movement speed of the substrate P) to be used during the exposure of the substrate P based on the measurement results of the measuring apparatus 60 and the information that is stored in the storage apparatus MRY. Namely, the control apparatus CONT determines the movement speed of the substrate P that is to undergo the exposure process based on information that relates to the derived value "*U*" (information regarding the static contact angle "θ" and the sliding angle "α") and the permissible speed of the substrate P that corresponds to the value "*U*" and that is stored in advance in the storage apparatus MRY so that the movement speed does not exceed the permissible speed.

Furthermore, the control apparatus CONT performs an immersion exposure of the substrate P based on the determined exposure conditions (movement speed of the substrate P). For example, if the value "*U*" that is in accordance with the liquid LQ and the front surface of the substrate P that is to undergo the exposure process is small and the movement speed of the substrate P is increased, then there is a possibility that it will be difficult to fill the optical path space K1 with the liquid LQ satisfactorily, and consequently the control apparatus CONT decreases the movement speed of the substrate P in accordance with the value "*U*". In so doing, it is possible to expose the substrate P in a state wherein the optical path space K1 is filled with the liquid LQ satisfactorily. Moreover, if the value "*U*" is large, then the movement speed of the substrate P can be increased, which can improve throughput.

Furthermore, if throughput is taken into consideration, then it is preferable to set the movement speed of the substrate P to the permissible speed that corresponds to the value "*U*".

In addition, the movement speed of the substrate P includes not only the movement speed (scanning speed) during exposure when the substrate P is irradiated with the exposure light EL, but also the movement speed (stepping speed) during stepping, which is performed between shots.

As explained above, the exposure conditions to be used during the exposure of the substrate P are determined based on the equation ($\theta - t \times \alpha$), which makes it possible to perform an immersion exposure satisfactorily on each of the multiple substrates P whereon different types of film are formed. Accordingly, it is possible to improve the versatility of the immersion exposure apparatus EX.

Furthermore, in the present embodiment, the movement speed of the substrate P is determined based on the value "$U$"; however, at least one of the substrate P acceleration, deceleration, movement direction (movement trajectory), and distance of continuous movement in one direction can be determined. Namely, the relationship between the value "$U$" and at least one of the maximum acceleration, the maximum deceleration, and the maximum movement distance at which the immersion region LR on the substrate P can be maintained in a desired state may be derived in advance, and at least one of the acceleration, the deceleration, and the movement distance may be determined so that each one does not exceed the permissible value derived from the value "$U$" that corresponds to the liquid LQ and the film of the substrate P. In addition, if the value "$U$" is small, then, depending on the movement direction of the substrate P, there is also a possibility that the immersion region LR cannot be maintained in the desired state, and therefore the movement direction of the substrate P may be restricted in accordance with the value "$U$", and the speed when the substrate P is moved in a prescribed direction may be set lower than the speed when it is moved in another direction.

In addition, it is possible to determine, based on the value "$U$", the liquid immersion conditions to be used when forming the immersion region LR, which includes the supply conditions to be used when supplying the liquid LQ so as to form the immersion region LR and the recovery conditions to be used when recovering the liquid LQ that forms the immersion region LR. For example, if the relationship between the value "$U$" and the maximum liquid supply rate at which the immersion region LR on the substrate P can be maintained in the desired state is derived in advance, then the supply rate of the liquid LQ may be determined so that it does not exceed a permissible value that is derived from the value "$U$".

In addition, in the fourth embodiment, the permissible range of the value "$U$" may be set and, before exposing the substrate P, it may be determined whether that substrate P has a film with a value "$U$" that is in the permissible range with respect to the liquid (pure water) LQ, i.e., whether it is a substrate P that has a film that is appropriate for the immersion exposure process.

In addition, in the fourth embodiment, the first measuring apparatus, which measures the static contact angle "$\theta$" of the liquid LQ on the front surface of the substrate P, and the second measuring apparatus, which measures the sliding angle "$\alpha$" of the liquid LQ on the front surface of the substrate P, may be provided separately.

Furthermore, the fourth embodiment discussed above explained that the droplet of the liquid LQ is disposed on the front surface of the substrate P that is actually to be exposed in order to fabricate a device, and that the measuring apparatus 60 measures the state of the droplet when that substrate P is inclined; however, the droplet may be disposed on, for example, an object (e.g., a test substrate) that has a front surface that is substantially the same as the front surface of the substrate P that is actually to be exposed, and the state of the droplet when the front surface of that object is inclined may be measured.

<Fifth Embodiment>

In the fourth embodiment discussed above, it is possible to measure the static contact angle "$\theta$" and the sliding angle "$\alpha$" using an apparatus that is separate from the exposure apparatus EX, without installing the measuring apparatus 60 in the exposure apparatus EX. Furthermore, in order to determine the exposure conditions to be used during the exposure of the substrate P, the information regarding the static contact angle "$\theta$" of the liquid LQ on the front surface of the substrate P and the information regarding the sliding angle "$\alpha$" of the liquid LQ on the front surface of the substrate P are input to the control apparatus CONT via the input apparatus INP. The control apparatus CONT determines the exposure conditions to be used during the exposure of the substrate P based on the information regarding the contact angle "$\theta$" and the information regarding the sliding angle "$\alpha$", which were input from the input apparatus INP. Namely, similar to the embodiments discussed above, the control apparatus CONT derives the value "$U$" based on the information regarding the contact angle "$\theta$" and the information regarding the sliding angle "$\alpha$" that were input from the input apparatus INP and, based on that derived value "$U$" and information that derives-from the value "$U$"-the conditions under which the immersion region LR can be maintained in the desired state and that is stored in the storage apparatus MRY in advance, determines the optimum exposure conditions for the substrate P that is to undergo the exposure process. Of course, the optimum exposure conditions may be determined by inputting the value "$U$" from the input apparatus INP.

<Sixth Embodiment>

The sixth embodiment will now be explained. The characteristic feature of the present embodiment lies in the fact that the exposure conditions to be used during the exposure of the substrate P are determined based on a receding contact angle of the liquid LQ on the front surface of the substrate P when the front surface of the substrate P is inclined.

In the present embodiment, the control apparatus CONT determines the exposure conditions to be used during the exposure of the substrate P based on a receding contact angle "$\theta_R$" of the liquid LQ on the front surface of the substrate P when the front surface of the substrate P is inclined.

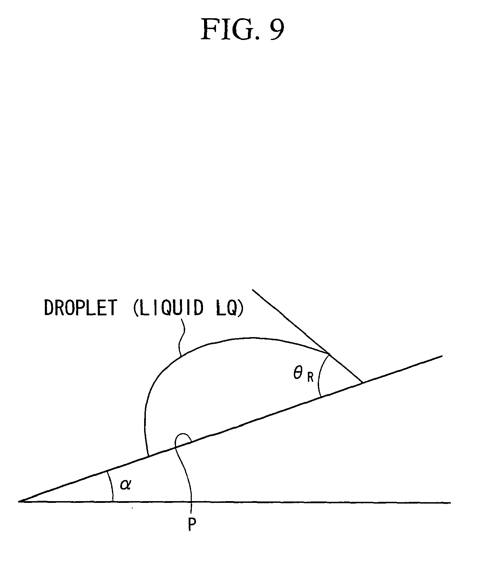

The receding contact angle "$\theta_R$" will now be explained, referencing the schematic drawing in FIG. 9. The receding contact angle "$\theta_R$" refers to the contact angle on the rear side of the droplet at which, when the front surface of the object is inclined with respect to the horizontal plane in a state wherein the liquid LQ droplet is adhered to the front surface of the object (herein, the front surface of the substrate P), the liquid LQ droplet that is adhered to the front surface of the object begins to slide (begins to move) downward as a result of the action of gravity. In other words, the receding contact angle "$\theta_R$" refers to the contact angle on the rear side of the droplet that, when the front surface of the object to which the liquid LQ droplet is adhered is inclined, is the critical angle, i.e., the sliding angle "$\alpha$", at which that droplet begins to slide downward. Furthermore, the point in time when the liquid LQ droplet that is adhered to the front surface of the object begins to slide (starts to move) downward as a result of the action of gravity refers to the instant that the droplet begins to move; however, it is also possible to refer to at least one of the state immediately before the start of movement or the state immediately after the start of movement.

The present inventor found that the exposure conditions (for example, the movement conditions of the substrate P and the liquid immersion conditions) under which the immersion region LR on the substrate P can be maintained in the desired state vary in accordance with the receding contact angle "$\theta_R$" of the liquid LQ on the front surface of the substrate P. Namely, the present inventor found that, when the space between the film of the substrate P and the last optical element LS 1 of the exposure apparatus EX is filled with the liquid LQ and the immersion region LR of the liquid LQ is formed on the substrate P, the exposure conditions under which the immersion region LR can be maintained in the desired state vary in accordance with the receding contact angle "$\theta_R$" that corresponds to the liquid LQ and the film of the substrate P. Accordingly, setting the optimal exposure conditions in accordance with the receding contact angle "$\theta_R$" makes it possible to expose the substrate P without the occurrence of problems such as the liquid LQ flowing out or the generation of bubbles in the liquid LQ.

For example, the exposure conditions include the movement speed of the substrate P. Namely, when the space between the film of the substrate P and the last optical element LS 1 of the exposure apparatus EX is filled with the liquid LQ and the immersion region LR of the liquid LQ is formed on the substrate P, the maximum speed (permissible speed) at which the immersion region LR can be maintained in the desired state varies in accordance with the receding contact angle "$\theta_R$" that corresponds to the film of the substrate P and the liquid LQ. Accordingly, if the substrate P moves at a speed that is lower than the permissible speed that corresponds to the receding contact angle "$\theta_R$", then it is possible to expose the substrate P while suppressing the occurrence of problems such as the liquid LQ flowing out or the generation of bubbles in the liquid LQ.

The receding contact angle "$\theta_R$" can be measured by using the measuring apparatus 60 discussed above. When the receding contact angle "$\theta_R$" of the liquid LQ on the front surface of the substrate P is measured, the measuring apparatus 60 first uses the drive system 65 to adjust the position (attitude) of the holding member 61 so that the front surface of the substrate P held by the holding member 61 is substantially parallel to the horizontal plane (XY plane). Furthermore, the measuring apparatus 60 uses the drip feeding member 62 to drip the liquid LQ droplet onto the front surface of the substrate P, which is substantially parallel to the horizontal plane. Furthermore, similar to the procedure that was explained referencing FIG. 4, the measuring apparatus 60 uses the drive system 65 to rotate (incline) the holding member 61, which holds the substrate P in a state wherein the droplet is disposed on the front surface of the substrate P, in the θX directions. As the holding member 61 rotates (inclines), the front surface of the substrate P also rotates (inclines). As the front surface of the substrate P rotates (inclines), the droplet that is adhered to the front surface of the substrate P begins to slide (begins to move) downward as a result of the action of gravity. At this time, the measuring apparatus 60 uses the illumination apparatus 64 to illuminate the droplet that is disposed on the front surface of the substrate P, and uses the observing apparatus 63 to obtain an image of the droplet. The observing apparatus 63 is capable of observing the fact that the droplet begins to slide, and outputs image information that relates to the obtained image to the control apparatus CONT. The control apparatus CONT can derive the point in time when the droplet on the front surface of the substrate P begins to move (the point in time when it begins to slide) based on the signal (image information) that is output by the observing apparatus 63. Furthermore, the control apparatus CONT performs arithmetic processing (image processing) on the signal that is output by the observing apparatus 63 and, based on such processing results, can derive the receding contact angle "$\theta_R$" of the liquid LQ droplet on the front surface of the substrate P. Thus, the measuring apparatus 60, which includes the control apparatus CONT, measures the receding contact angle "$\theta_R$" of the liquid LQ on the front surface of the substrate P.

In addition, based on the drive quantity (degree of inclination) with which the drive system 65 drives the holding member 61, the control apparatus CONT can derive the angle (i.e., the sliding angle) "$\alpha$" of the front surface of the substrate P at the point in time when the droplet on the front surface of the substrate P begins to move. Namely, the control apparatus CONT can derive the sliding angle "$\alpha$" of the liquid LQ droplet on the front surface of the substrate P based on the signal (image information) that is output from the observing apparatus 63 and the drive quantity with which the drive system 65 drives the holding member 61. Thus, the measuring apparatus 60, which includes the control apparatus CONT, measures the sliding angle "$\alpha$" of the liquid LQ on the front surface of the substrate P.

In addition, based on the signal (image information) that is output by the observing apparatus 63, the control apparatus CONT can display the image of the droplet on the front surface of the substrate P on the display apparatus DY. Accordingly, the receding contact angle "$\theta_R$" of the liquid LQ on the front surface of the substrate P at the point in time when the droplet on the front surface of the substrate P begins to move may be measured visually by displaying the state of the droplet on the display apparatus DY.

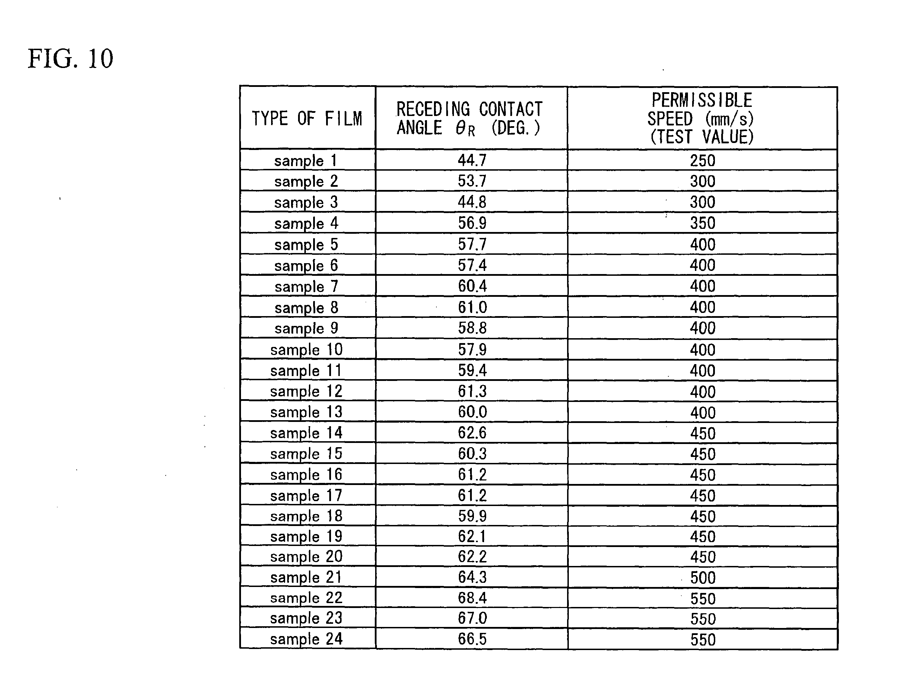

FIG. 10 shows one example of the results of a test that was conducted in order to derive the relationship between the receding contact angle "$\theta_R$" and the permissible speed. The test varied the type of the film provided to the uppermost layer of the substrate P (the front surface of the substrate P), and measured the receding contact angle "$\theta_R$" of the liquid LQ on each film of the plurality of film types and the permissible speed of the substrate P for each of the films. Furthermore, the permissible speeds of the substrate P shown in the test example in FIG. 10 are the speeds at which the substrate P can be moved while the optical path space K1 is filled with the liquid LQ without that liquid LQ flowing out (without leaving behind any drop or film of the liquid LQ on the substrate P). In addition, as shown in FIG. 10, 24 types of film were prepared for the present test example, and data were obtained for each of the films.

As discussed above, the measuring apparatus 60 is capable of measuring the receding contact angle "$\theta_R$" of the liquid LQ on the front surface of the substrate P; therefore, in the present test example, several tens of microliters (e.g., 50 $\mu\ell$) of the liquid LQ were dripped onto the front surface of each film, and the measuring apparatus 60 was used to derive the receding contact angle "$\theta_R$" of the liquid LQ for each film.

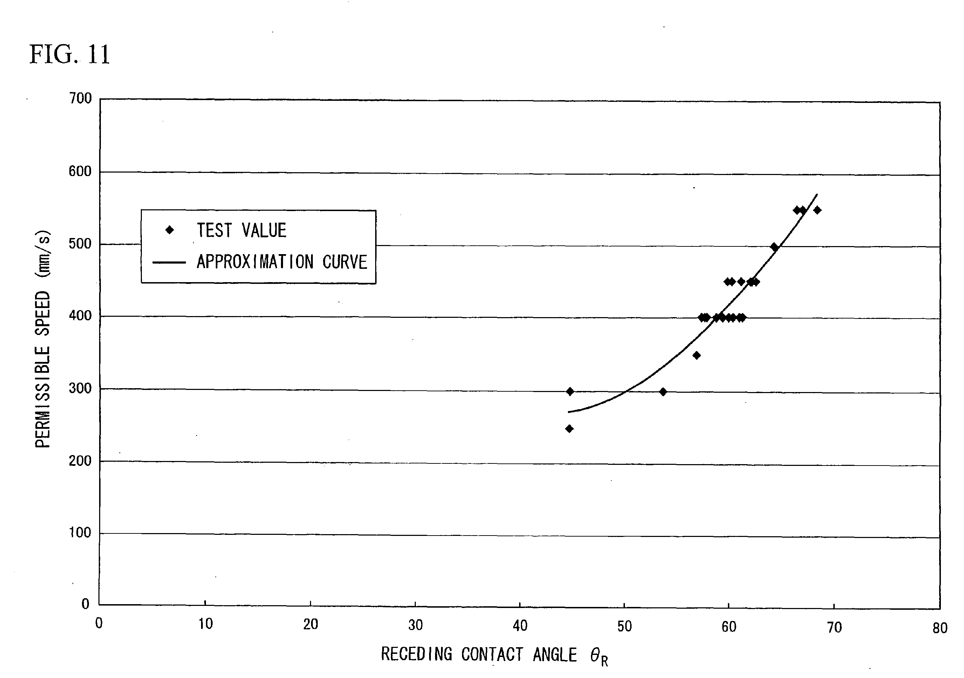

FIG. 11 shows the relationship between the receding contact angle "$\theta_R$" and the permissible speed, i.e., it graphs the test results in FIG. 10. FIG. 11 shows the data points that correspond to the test results discussed above, as well as an approximation curve that fits those test results. As shown in FIG. 11, it can be seen that the permissible speed varies with the receding contact angle "$\theta_R$" of the liquid LQ on the front surface of the substrate P. Specifically, it can be seen that the greater the receding contact angle "$\theta_R$" becomes, the greater the permissible speed becomes. Accordingly, the provision of a film with a large receding contact angle "$\theta_R$" with respect to the liquid LQ on the substrate P makes it possible to expose that substrate P while moving it at high speed in a state wherein the space between the last optical element LS 1 and the substrate P (film) is filled with the liquid LQ.

Next, one example of a measurement procedure that uses the measuring apparatus 60 and an exposure procedure that is used during the exposure of the substrate P will be explained. During the exposure of the substrate P that has a prescribed film, the control apparatus CONT uses the measuring apparatus 60 to measure, prior to exposing that substrate P, the receding contact angle "$\theta_R$" of the liquid LQ on the front surface (film) of the substrate P. Furthermore, the control apparatus CONT determines the exposure conditions to be used when the substrate P is exposed based on the measurement results of the measuring apparatus 60, i.e., on the receding contact angle "$\theta_R$". In the present embodiment, as part of the determination of the exposure conditions, the control apparatus CONT determines the movement conditions (movement speed of the substrate P) to be used when the substrate P is moved.

Herein, the storage apparatus MRY stores information (function, map data, and the like) in advance for deriving the permissible speed of the substrate P that corresponds to the receding contact angle "$\theta_R$" of the liquid LQ. In the present embodiment, the storage apparatus MRY stores, as a receding contact angle "$\theta_R$" parameter, a function (e.g., a function that corresponds to the approximation curve in FIG. 11) that derives the permissible speed of the substrate P that corresponds to the receding contact angle "$\theta_R$". The information that relates to the permissible speed of the substrate P that corresponds to the receding contact angle "$\theta_R$" can be derived in advance either empirically or by simulation, and is stored in the storage apparatus MRY.

The control apparatus CONT determines the exposure conditions (movement speed of the substrate P) to be used during the exposure of the substrate P based on the measurement results of the measuring apparatus 60 and the information that is stored in the storage apparatus MRY. Namely, the control apparatus CONT determines the optimal movement speed of the substrate P that is to undergo the exposure process based on information that relates to the derived receding contact angle "$\theta_R$" of the liquid LQ and the permissible speed of the substrate P that corresponds to the receding contact angle "$\theta_R$" and that is stored in advance in the storage apparatus MRY so that the movement speed does not exceed the permissible speed.

Furthermore, the control apparatus CONT performs an immersion exposure of the substrate P based on the determined exposure conditions (movement speed of the substrate P). For example, if the receding contact angle "$\theta_R$" of the liquid LQ is small and the movement speed of the substrate P is increased, then there is a possibility that it will be difficult to fill the optical path space K1 with the liquid LQ satisfactorily, and consequently the control apparatus CONT decreases the movement speed of the substrate P in accordance with the receding contact angle "$\theta_R$" of the liquid LQ. In so doing, it is possible to expose the substrate P in a state wherein the optical path space K1 is filled with the liquid LQ satisfactorily. Moreover, if the receding contact angle "$\theta_R$" of the liquid LQ is large, then the movement speed of the substrate P can be increased, which can improve throughput.

Furthermore, if throughput is taken into consideration, then it is preferable to set the movement speed of the substrate P to the permissible speed that corresponds to the receding contact angle "$\theta_R$".

In addition, the movement speed of the substrate P includes not only the movement speed (scanning speed) during exposure when the substrate P is irradiated with the exposure light EL, but also the movement speed (stepping speed) during stepping, which is performed between shots.

As explained above, the exposure conditions to be used during the exposure of the substrate P are determined based on the receding contact angle "$\theta_R$" of the liquid LQ on the front surface of the substrate P, which makes it possible to perform an immersion exposure satisfactorily on each of the multiple substrates P whereon different types of film are formed. Accordingly, it is possible to improve the versatility of the immersion exposure apparatus EX.

Furthermore, in the present embodiment, the movement speed of the substrate P is determined based on the receding contact angle "$\theta_R$" of the liquid LQ; however, at least one of the substrate P acceleration, deceleration, movement direction (movement trajectory), and distance of continuous movement in one direction can be determined. Namely, the relationship between the receding contact angle "$\theta_R$" and at least one of the maximum acceleration, the maximum deceleration, and the maximum movement distance at which the immersion region LR on the substrate P can be maintained in a desired state may be derived in advance, and at least one of the acceleration, the deceleration, and the movement distance may be determined so that each one does not exceed the permissible value derived from the receding contact angle "$\theta_R$" that corresponds to the liquid LQ and the film of the substrate P. In addition, if the receding contact angle "$\theta_R$" is small, then, depending on the movement direction of the substrate P, there is also a possibility that the immersion region LR cannot be maintained in the desired state, and therefore the movement direction of the substrate P may be restricted in accordance with the receding contact angle "$\theta_R$", and the speed when the substrate P is moved in a prescribed direction may be set lower than the speed when it is moved in another direction.

In addition, it is possible to determine, based on the angle "$\theta_R$", the liquid immersion conditions to be used when forming the immersion region LR, which includes the supply conditions to be used when supplying the liquid LQ so as to form the immersion region LR and the recovery conditions to be used when recovering the liquid LQ that forms the immersion region LR. For example, if the relationship between the receding contact angle "$\theta_R$" and the maximum liquid supply rate at which the immersion region LR on the substrate P can be maintained in the desired state is derived in advance, then the supply rate of the liquid LQ may be determined so that it does not exceed a permissible value that is derived from the receding contact angle "$\theta_R$".

In addition, in the sixth embodiment, the permissible range of the receding contact angle "$\theta_R$" of the liquid LQ may be set and, before exposing the substrate P, it may be determined whether that substrate P has a film with a receding contact angle "$\theta_R$" that is in the permissible range with respect to the liquid (pure water) LQ, i.e., whether it is a substrate P that has a film that is appropriate for the immersion exposure process.

Furthermore, the sixth embodiment discussed above explained that the droplet of the liquid LQ is disposed on the front surface of the substrate P that is actually to be exposed in order to fabricate a device, and that the measuring apparatus 60 measures the state of the droplet when that substrate P is inclined; however, the droplet may be disposed on, for example, an object (e.g., a test substrate) that has a front surface that is substantially the same as the front surface of the substrate P that is actually to be exposed, and the state of the droplet when the front surface of that object is inclined may be measured.

<Seventh Embodiment>

In addition, in the sixth embodiment discussed above, it is possible to measure the receding contact angle "$\theta_R$" of the liquid LQ on the front surface of the substrate P using an apparatus that is separate from the exposure apparatus EX, without installing the measuring apparatus 60 in the exposure apparatus EX. Furthermore, in order to determine the exposure conditions to be used during the exposure of the substrate P, the information regarding the receding contact angle "$\theta_R$" of the liquid LQ on the front surface of the substrate P is input to the control apparatus CONT via the input apparatus INP. The control apparatus CONT determines the exposure conditions to be used during the exposure of the substrate P based on the information regarding the receding contact angle "$\theta_R$", which was input from the input apparatus INP. Namely, the control apparatus CONT determines the optimum exposure conditions for the substrate P that is to undergo the exposure process based on the information regarding the receding contact angle "$\theta_R$", which was input from the input apparatus INP, and based on information that derives-from the receding contact angle "$\theta_R$"-the conditions under which the immersion region LR can be maintained in the desired state and that is stored in the storage apparatus MRY in advance.

Furthermore, in the first through seventh embodiments discussed above, the information that is stored in the storage apparatus MRY may be updated at any time as needed. For example, during the exposure of a substrate P that has yet another type of film that is not stored in the storage apparatus MRY, the information that is stored in the storage apparatus MRY should be updated by conducting a test or a simulation on the new film, and deriving the exposure conditions that correspond to its adhesive force (the static contact angle and the sliding angle). Likewise, the information that is stored in the storage apparatus MRY should be updated by conducting a test or a simulation on the new film and deriving the exposure conditions that correspond to the receding contact angle. In addition, the stored information can be updated by using a communication apparatus that includes, for example, the Internet to communicate with the exposure apparatus EX (the storage apparatus MRY) from a remote location.

In addition, in the first through seventh embodiments discussed above, if the movement conditions of the substrate P are determined based on the adhesive force E (the static contact angle and the sliding angle) or the receding contact angle, then dose control parameters are adjusted based on those movement conditions. Namely, based on the substrate P movement conditions that were determined, the control apparatus CONT adjusts at least one of the light quantity (intensity) of the exposure light EL, the pulse oscillation period of the laser light, and the width of the projection area AR-over which the exposure light EL is irradiated-in the scanning directions, and optimizes the dose for each of the shot regions on the substrate P.

In addition, in the first through seventh embodiments discussed above, if the adhesive force E of the film on the front surface of the substrate P, the static contact angle "θ", the sliding angle "α", the receding contact angle "$\theta_R$", and the like vary before and after the exposure light EL is irradiated, then the movement conditions of the substrate P, the liquid immersion conditions, and the like may be modified before and after such irradiation. If the adhesive force "$E$" of the film on the front surface of the substrate P, the static contact angle "θ", the sliding angle "α", the receding contact angle "$\theta_R$", and the like vary in accordance with at least one of the presence of exposure light EL irradiation, the duration of contact with the liquid LQ, and the elapsed time since the formation of the film on the front surface of the substrate P, then it is preferable to determine the exposure conditions, such as the movement conditions of the substrate P and the liquid immersion conditions, by taking into consideration at least one of the presence of exposure light EL irradiation, the duration of contact with the liquid LQ, and the elapsed time since the formation of the film on the front surface of the substrate P.

In addition, in the first through seventh embodiments discussed above, the exposure conditions are determined based on the adhesive force E (the static contact angle "θ" and the sliding angle "α") or the receding contact angle "$\theta_R$", but they may be determined by taking other physical properties of the liquid LQ into consideration (e.g., its viscosity, volatility, fluid resistance, surface tension, refractive index temperature dependency $dn/dT$, and dissolution characteristic in the atmosphere, i.e., the ease with which gas that contacts the liquid LQ dissolves therein).

In addition, in the first through seventh embodiments discussed above, the exposure conditions were determined based on the adhesive force E (the static contact angle "θ" and the sliding angle "α") or the receding contact angle "$\theta_R$", but they may be determined based on the sliding condition at the interface between the liquid and the film that is formed on the front surface of the substrate P (e.g., the relative speed between the film and the liquid at the interface therebetween when the substrate P moves substantially parallel to the front surface of the substrate P at a prescribed speed in a state wherein the immersion region is formed on the substrate P).

In addition, in the first through seventh embodiments discussed above, the movement conditions of the substrate P, the liquid immersion conditions, and the like are determined in accordance with the film on the front surface of the substrate P; however, if the immersion region is formed on an object other than the substrate P such as the upper surface 97 of the substrate stage PST, then it is preferable to determine the movement conditions of the substrate stage PST, the liquid immersion conditions on the substrate stage PST, and the like in accordance with the film on the front surface of that object.

As discussed above, the liquid LQ in the present embodiment is pure water. Pure water is advantageous because it can be obtained easily in large quantities at, for example, a semiconductor fabrication plant, and does not affect, for example, the optical element (lens) or the photoresist on the substrate P adversely. In addition, because pure water does not impact the environment adversely and has an extremely low impurity content, it can also be expected to have the effect of cleaning the front surface of the substrate P and the surface of the optical element provided to the tip surface of the projection optical system PL.

Further, the refractive index "$n$" of pure water (water) with respect to exposure light EL that has a wavelength of approximately 193 nm is said to be substantially 1.44; therefore, the use of ArF excimer laser light (193 nm wavelength) as the light source of the exposure light EL shortens the wavelength on the substrate P to 1/n, i.e., approximately 134 nm, and thereby a high resolution is obtained. Furthermore, because the depth of focus when pure water is used is approximately "$n$" times, i.e., approximately 1.44 times, that of when air is used, the numerical aperture of the projection optical system PL can be increased further if it is preferable to ensure a depth of focus that is approximately the same as that when air is used, and the resolution is improved from this standpoint as well.

In the present embodiment, the optical element LS 1 is affixed to the tip of the projection optical system PL and can adjust the optical characteristics of the projection optical system PL, e.g., aberrations (spherical aberration, coma aberration, and the like). Furthermore, the optical element that is affixed to the tip of the projection optical system PL may also be an optical plate that is used to adjust the optical characteristics of the projection optical system PL. Alternatively, it may be a plane parallel plate that is capable of transmitting the exposure light EL therethrough.

Furthermore, if high pressure is generated by the flow of the liquid LQ between the substrate P and the optical element at the tip of the projection optical system PL, then instead of making that optical element replaceable, it may be fixed firmly by that pressure so that it does not move.

Furthermore, the present embodiment is constituted so that the liquid LQ is filled between the projection optical system PL and the front surface of the substrate P, but it may be constituted so that the liquid LQ is filled in a state wherein, for example, a cover glass that comprises a plane parallel plate is affixed to the front surface of the substrate P.

In addition, the projection optical system of the embodiments discussed above fills the liquid in the space of the optical path on the image plane side of the tip optical element, but it is also possible to employ a projection optical system that fills the liquid in the optical path space on the object surface side of the tip optical element as well, as disclosed in PCT International Publication No. WO 2004/019128.

Furthermore, as discussed above, although the liquid LQ in the present embodiment is water, it may be a liquid other than water; for example, if the light source of the exposure light EL is an $F_2$ laser, then this $F_2$ laser light will not transmit through water, so it would be acceptable to use a fluorine based fluid that is capable of transmitting $F_2$ laser light, such as perfluorinated polyether (PFPE) or fluorine based oil, as the liquid LQ. In this case, the parts of the projection optical system PL that make contact with the liquid LQ are treated so as to make them lyophilic by forming a thin film with, for example, a substance that has a molecular structure that contains fluorine and has low polarity. In addition, it is also possible to use a liquid (e.g., cedar oil) that is transparent to the exposure light EL, has the highest possible refractive index, and is stable with respect to the projection optical system PL and/or the photoresist coated on the front surface of the substrate P as the liquid LQ.

In addition, a liquid that has a refractive index of approximately 1.6 to 1.8 may be used as the liquid LQ. Furthermore, the optical element LS1 may be formed from a material that has a refractive index that is higher than quartz or fluorite (e.g., 1.6).

Furthermore, the substrate P in each of the abovementioned embodiments is not limited to a semiconductor wafer for fabricating semiconductor devices, and is also applicable to, for example, a glass substrate for a display device, a ceramic wafer for a thin film magnetic head, and a mask or the original plate of a reticle (synthetic quartz or a silicon wafer) used by an exposure apparatus.

The exposure apparatus EX can also be adapted to a step-and-scan type scanning exposure apparatus (scanning stepper) that scans and exposes the pattern of the mask M by synchronously moving the mask M and the substrate P, as well as to a step-and-repeat type projection exposure apparatus (stepper) that performs full field exposure of the pattern of the mask M with the mask M and the substrate P in a stationary state, and sequentially steps the substrate P.

In addition, the exposure apparatus EX can also be adapted to an exposure apparatus that uses a projection optical system (e.g., a dioptric projection optical system, which does not include a reflecting element, that has a 1/8 reduction magnification) to expose the substrate P with the full field of a reduced image of a first pattern in a state wherein the first pattern and the substrate P are substantially stationary. In this case, the exposure apparatus EX can also be adapted to a stitching type full field exposure apparatus that subsequently further uses that projection optical system to expose the substrate P with the full field of a reduced image of a second pattern, in a state wherein the second pattern and the substrate P are substantially stationary, so that the second pattern partially overlaps the first. In addition, the stitching type exposure apparatus can also be adapted to a step-and-stitch type exposure apparatus that transfers at least two patterns onto the substrate P so that they partially overlap, and sequentially steps the substrate P.

In addition, the present invention can also be adapted to a twin stage type exposure apparatus, which comprises a plurality of substrate stages, as disclosed in, for example, Japanese Unexamined Patent Application Publication No. H10-163099, Japanese Unexamined Patent Application Publication No. H10-214783, and Published Japanese Translation No. 2000-505958 of the PCT International Publication.

Furthermore, as disclosed in Japanese Unexamined Patent Application Publication No. H11-135400 and Japanese Unexamined Patent Application Publication No. 2000-164504, the present invention can also be adapted to an exposure apparatus that is provided with a substrate stage that holds the substrate, and a measurement stage whereon a fiducial member (wherein a fiducial mark is formed) and various photoelectric sensors are mounted.

In addition, in the embodiments discussed above, an exposure apparatus is employed that locally fills the liquid between the projection optical system PL and the substrate P; however, the present invention can also be adapted to a liquid immersion exposure apparatus that exposes the entire front surface of a substrate to be exposed in a state wherein the substrate is immersed in liquid, as disclosed in, for example, Japanese Unexamined Patent Application Publication No. H6-124873, Japanese Unexamined Patent Application Publication No. H10-303114, and U.S. Patent No. 5,825,043.

The type of exposure apparatus EX is not limited to semiconductor device fabrication exposure apparatuses that expose the pattern of a semiconductor device on the substrate P, but can also be adapted widely to exposure apparatuses for fabricating liquid crystal display devices or displays, and exposure apparatuses for fabricating, for example, thin film magnetic heads, imaging devices (CCDs), or reticles and masks.

Furthermore, in the abovementioned embodiments, a light transmitting type mask is used wherein a prescribed shielding pattern (or a phase pattern and dimming pattern) is formed on a light transmitting substrate; however, instead of such a mask, it is also possible to use an electronic mask, wherein a transmittance pattern, a reflected pattern, or a light emitting pattern is formed based on electronic data of the pattern to be exposed, as disclosed in, for example, U.S. Patent No. 6,778,257.

In addition, by forming interference fringes on the substrate P, as disclosed in PCT International Publication No. WO2001/035168, the present invention can also be adapted to an exposure apparatus (lithographic system) that exposes the substrate P with a line-and-space pattern.

The exposure apparatus EX of the embodiments in the present application is manufactured by assembling various subsystems that include each constituent element recited in the claims of the present application so that prescribed mechanical, electrical, and optical accuracies are maintained. To ensure these various accuracies, adjustments are performed before and after this assembly, including an adjustment to achieve optical accuracy for the various optical systems, an adjustment to achieve mechanical accuracy for the various mechanical systems, and an adjustment to achieve electrical accuracy for the various electrical systems. The process of assembling the exposure apparatus EX from the various subsystems includes, for example, the mechanical interconnection of the various subsystems, the wiring and connection of electrical circuits, and the piping and connection of the atmospheric pressure circuit. Naturally, before the process of assembling the exposure apparatus EX from these various subsystems, there are also the processes of assembling each individual subsystem. When the process of assembling the exposure apparatus EX from the various subsystems is complete, a comprehensive adjustment is performed to ensure the various accuracies of the exposure apparatus EX as a whole. Furthermore, it is preferable to manufacture the exposure apparatus in a clean room wherein, for example, the temperature and the cleanliness level are controlled.

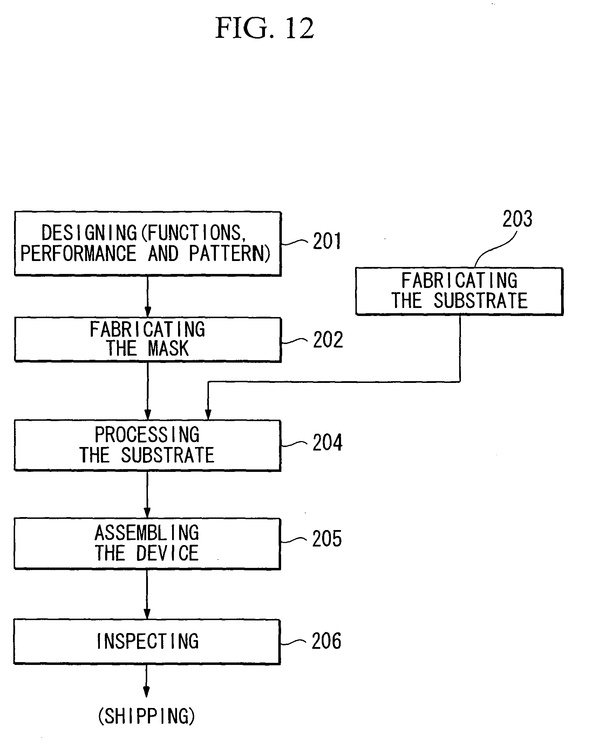

As shown in FIG. 12, a micro-device, such as a semiconductor device, is manufactured by: a step 201 that designs the functions and performance of the micro-device; a step 202 that fabricates a mask (reticle) based on this design step; a step 203 that fabricates a substrate, which is the base material of the device; a step 204 that includes a process wherein the exposure apparatus EX of the embodiments discussed above exposes the substrate with a pattern of the mask; a device assembling step 205 (comprising a dicing process, a bonding process, and a packaging process); an inspecting step 206; and the like.

## Claims

1. An exposing method, comprising:

    forming an immersion region of a liquid on a substrate;
    determining exposure conditions in accordance with an adhesive force that acts between a surface of the substrate and the liquid; and
    exposing the substrate through the liquid of the immersion region based on the exposure conditions.

2. An exposing method according to Claim 1, wherein
    the adhesive force is prescribed in accordance with a static contact angle of the liquid on the surface of the substrate and a sliding angle of the liquid on the surface of the substrate.

3. An exposing method according to Claim 1 or Claim 2, wherein
    the adhesive force "$E$" is defined by $E = (m \times g \times \sin \alpha)/(2 \times \pi \times R)$, where "$m$" is the mass of a droplet of the liquid on the substrate, "g" is gravitational acceleration, "$\alpha$" is the sliding angle with respect to the horizontal plane, and "$R$" is the radius of the liquid droplet on the substrate.

4. An exposing method, comprising:

    forming an immersion region of a liquid on a substrate;
    determining exposure conditions based on a static contact angle of the liquid on a surface of the substrate and a sliding angle of the liquid on the surface of the substrate; and
    exposing the substrate through the liquid of the immersion region based on the exposure conditions.

5. An exposing method according to Claim 4, wherein
    the exposure conditions are determined based on an equation $(\theta - t \times \alpha)$, where "$\theta$" is the static contact angle of the liquid on the surface of the substrate, "α" is the sliding angle of the liquid on the surface of the substrate, and "$t$" is a prescribed constant.

6. An exposing method according to any one of Claims 2 to 5, wherein
the determination of the exposure conditions comprises:

measuring the static contact angle of the liquid on the surface of the substrate; and
measuring the sliding angle of the liquid on the surface of the substrate.

7. An exposing method, comprising:

forming an immersion region of a liquid on a substrate;
determining exposure conditions based on a receding contact angle of the liquid on a surface of the substrate when the substrate is inclined; and
exposing the substrate through the liquid of the immersion region based on the exposure conditions.

8. An exposing method according to any one of Claims 1 to 7, wherein
the exposure of the substrate comprises irradiating the substrate with exposure light through the liquid while the substrate is moved; and
the exposure conditions include movement conditions to be used when the substrate is moved.

9. An exposing method according to Claim 8, wherein
the movement conditions include at least one of movement speed and acceleration of the substrate.

10. An exposing method according to any one of Claims 1 to 9, wherein
the exposure conditions include liquid immersion conditions to be used when the immersion region is formed.

11. An exposing method according to Claim 10, wherein
the liquid immersion conditions include supply conditions of the liquid to be supplied to the immersion region.

12. An exposing method according to Claim 11, wherein
the supply conditions include a liquid supply quantity per unit of time.

13. A device fabricating method that uses an exposing method according to any one of Claims 1 to 12.

14. An exposure apparatus that exposes a substrate through a liquid of an immersion region that is formed on the substrate, the exposure apparatus comprising:

a measuring apparatus that measures an adhesive force that acts between a surface of the substrate and the liquid.

15. An exposure apparatus according to Claim 14, wherein
the measuring apparatus comprises:

a first measuring instrument that measures a static contact angle of the liquid on the surface of the substrate; and
a second measuring instrument that measures a sliding angle of the liquid on the surface of the substrate.

16. An exposure apparatus that exposes a substrate through a liquid of an immersion region that is formed on the substrate, comprising:

a measuring apparatus that measures a receding contact angle of the liquid on a surface of the substrate when the substrate is inclined.

17. An exposure apparatus according to Claim 14 or Claim 15, further comprising:

a storage apparatus that stores information that corresponds to the adhesive force in advance; and
a control apparatus that determines exposure conditions based on a measurement result of the measuring apparatus and on the information that is stored in the storage apparatus.

**18.** An exposure apparatus according to Claim 14 or Claim 15, further comprising:

a control apparatus that determines the exposure conditions based on the measurement result of the measuring apparatus.

**19.** An exposure apparatus according to Claim 16, further comprising:

a storage apparatus that stores information that corresponds to the receding contact angle in advance; and a control apparatus that determines exposure conditions based on the measurement result of the measuring apparatus and on the information that is stored in the storage apparatus.

**20.** An exposure apparatus according to Claim 16, further comprising:

a control apparatus that determines exposure conditions based on the measurement result of the measuring apparatus.

**21.** An exposure apparatus that exposes a substrate through a liquid of an immersion region that is formed on the substrate, comprising:

a first measuring apparatus that measures a static contact angle of the liquid on a surface of the substrate; a second measuring apparatus that measures a sliding angle of the liquid on the surface of the substrate; and a control apparatus that determines exposure conditions based on a measurement result of the first measuring apparatus and on a measurement result of the second measuring apparatus.

**22.** An exposure apparatus that exposes a substrate through a liquid of an immersion region that is formed on the substrate, the exposure apparatus comprising:

an input apparatus that inputs information regarding a static contact angle of the liquid on a surface of the substrate, and information regarding a sliding angle of the liquid on the surface of the substrate; and a control apparatus that determines exposure conditions based on the information regarding the contact angle and the information regarding the sliding angle that were input from the input apparatus.

**23.** An exposure apparatus according to Claim 21 or Claim 22, further comprising:

a storage apparatus that stores information that corresponds to the static contact angle and the sliding angle; wherein, the control apparatus determines the exposure conditions based on the information regarding the static contact angle and the sliding angle, and on the information that is stored in the storage apparatus.

**24.** An exposure apparatus according to any one of Claims 21 to 23, wherein the control apparatus determines the exposure conditions based on an equation $(\theta - t \times \alpha)$, where "$\theta$" is the static contact angle of the liquid on the surface of the substrate, "$\alpha$" is the sliding angle of the liquid on the surface of the substrate, and "$t$" is a prescribed constant.

**25.** An exposure apparatus that exposes a substrate through a liquid of an immersion region that is formed on the substrate, comprising:

an input apparatus that inputs information regarding a receding contact angle of the liquid on a surface of the substrate when the surface of the substrate is inclined; and a control apparatus that determines exposure conditions based on the information regarding the receding contact angle that was input from the input apparatus.

**26.** An exposure apparatus according to Claim 25, further comprising:

a storage apparatus that stores information that corresponds to the receding contact angle; wherein, the control apparatus determines the exposure conditions based on the information regarding the receding contact angle that was input from the input apparatus, and on the information that is stored in the storage apparatus.

**27.** An exposure apparatus according to any one of Claims 17 to 26, further comprising:

a movable member that is capable of holding and moving the substrate; wherein,
the control apparatus controls the operation of the movable member based on the exposure conditions.

**28.** An exposure apparatus according to any one of Claims 17 to 27, further comprising:

a liquid immersion mechanism that is capable of forming the immersion region; wherein,
the control apparatus controls the operation of the liquid immersion mechanism based on the exposure conditions.

**29.** A device fabricating method that uses an exposure apparatus according to any one of Claims 14 to 28.

**30.** A method of evaluating a film that is formed on a substrate that is exposed through a liquid, the method comprising:

measuring an adhesive force that acts between the film and the liquid; and
determining the applicability of the film for exposure conditions based on a comparison of the value of the adhesive force that was measured and a permissible range of the adhesive force, which is prescribed based on the exposure conditions.

**31.** An evaluating method according to Claim 30, wherein
the adhesive force is prescribed in accordance with a static contact angle of the liquid on a surface of the film, and a sliding angle of the liquid on the surface of the film.

**32.** A method of evaluating a film that is formed on a substrate that is exposed through a liquid, the method comprising:

measuring a receding contact angle of the liquid on a surface of the film when the substrate is inclined; and
determining the applicability of the film for exposure conditions based on a comparison of the value of the receding contact angle that was measured and a permissible range of the receding contact angle, which is prescribed based on the exposure conditions.

EP 1 879 219 A1

FIG. 1

# FIG. 2

# FIG. 3A

# FIG. 3B

FIG. 4

ILLUMINATION LIGHT

64

62

P

60

65

DRIVE SYSTEM

CONT

61

LQ

K2

DROPLET (LQ)

K1

ROTATION (INCLINATION)

63

DY

DISPLAY APPARATUS

CONTROL APPARATUS

CONT

Z

Y

X

EP 1 879 219 A1

# FIG. 5

# FIG. 6

```
┌─────────────────────────────────────────┐
│        MEASURE  CONTACT  ANGLE  θ        │──SA1
└─────────────────────────────────────────┘
                     │
                     ▼
┌─────────────────────────────────────────┐
│            DERIVE  RADIUS  R             │──SA2
└─────────────────────────────────────────┘
                     │
                     ▼
┌─────────────────────────────────────────┐
│        MEASURE  SLIDING  ANGLE  α        │──SA3
└─────────────────────────────────────────┘
                     │
                     ▼
┌─────────────────────────────────────────┐
│         DERIVE  ADHESIVE  FORCE  E       │──SA4
└─────────────────────────────────────────┘
                     │
                     ▼
┌─────────────────────────────────────────┐
│      DETERMINE  EXPOSURE  CONDITIONS     │──SA5
└─────────────────────────────────────────┘
                     │
                     ▼
┌─────────────────────────────────────────┐
│  EXPOSE  THE  SUBSTRATE  BASED  ON  THE  EXPOSURE  │──SA6
│   CONDITIONS  THAT  WERE  DETERMINED     │
└─────────────────────────────────────────┘
```

FIG. 7

| TYPE OF FILM | SLIDING ANGLE $\alpha$ (DEG.) | STATIC CONTACT ANGLE $\theta$ (DEG.) | CONTACT ANGLE $\theta$ - SLIDING ANGLE $\alpha$ | PERMISSIBLE SPEED (mm/s) (TEST VALUE) |
|---|---|---|---|---|
| sample 1 | 37.3 | 70.9 | 33.6 | 250 |
| sample 2 | 27.7 | 75.3 | 47.6 | 300 |
| sample 3 | 33.3 | 69.3 | 36.0 | 300 |
| sample 4 | 27.0 | 75.7 | 48.7 | 350 |
| sample 5 | 25.3 | 76.7 | 51.4 | 400 |
| sample 6 | 27.7 | 79.7 | 52.0 | 400 |
| sample 7 | 26.0 | 83.4 | 57.4 | 400 |
| sample 8 | 28.0 | 84.2 | 56.2 | 400 |
| sample 9 | 31.3 | 84.8 | 53.5 | 400 |
| sample 10 | 26.7 | 77.5 | 50.8 | 400 |
| sample 11 | 23.0 | 74.9 | 51.9 | 400 |
| sample 12 | 31 | 85.9 | 54.9 | 400 |
| sample 13 | 32 | 85.3 | 53.1 | 400 |
| sample 14 | 22.7 | 79.2 | 56.5 | 450 |
| sample 15 | 26.0 | 81.6 | 55.6 | 450 |
| sample 16 | 25.7 | 84.7 | 59.0 | 450 |
| sample 17 | 27.0 | 85.6 | 58.6 | 450 |
| sample 18 | 28.0 | 81.8 | 53.8 | 450 |
| sample 19 | 20.7 | 75.3 | 54.6 | 450 |
| sample 20 | 8 | 63.8 | 55.8 | 450 |
| sample 21 | 21 | 78.8 | 57.8 | 450 |
| sample 22 | 21.3 | 80.4 | 59.1 | 500 |
| sample 23 | 22 | 86.8 | 64.8 | 550 |
| sample 24 | 22 | 84.6 | 62.4 | 550 |
| sample 25 | 24 | 84.3 | 60.7 | 550 |
| sample 26 | 8 | 117.8 | 109.8 | 1500 |

EP 1 879 219 A1

FIG. 8

EP 1 879 219 A1

# FIG. 9

DROPLET (LIQUID LQ)

$\theta_R$

$\alpha$

P

FIG. 10

| TYPE OF FILM | RECEDING CONTACT ANGLE $\theta_R$ (DEG.) | PERMISSIBLE SPEED (mm/s) (TEST VALUE) |
|---|---|---|
| sample 1 | 44.7 | 250 |
| sample 2 | 53.7 | 300 |
| sample 3 | 44.8 | 300 |
| sample 4 | 56.9 | 350 |
| sample 5 | 57.7 | 400 |
| sample 6 | 57.4 | 400 |
| sample 7 | 60.4 | 400 |
| sample 8 | 61.0 | 400 |
| sample 9 | 58.8 | 400 |
| sample 10 | 57.9 | 400 |
| sample 11 | 59.4 | 400 |
| sample 12 | 61.3 | 400 |
| sample 13 | 60.0 | 400 |
| sample 14 | 62.6 | 450 |
| sample 15 | 60.3 | 450 |
| sample 16 | 61.2 | 450 |
| sample 17 | 61.2 | 450 |
| sample 18 | 59.9 | 450 |
| sample 19 | 62.1 | 450 |
| sample 20 | 62.2 | 450 |
| sample 21 | 64.3 | 500 |
| sample 22 | 68.4 | 550 |
| sample 23 | 67.0 | 550 |
| sample 24 | 66.5 | 550 |

FIG. 11

# FIG. 12

DESIGNING (FUNCTIONS, PERFORMANCE AND PATTERN) ~201

FABRICATING THE SUBSTRATE ~203

FABRICATING THE MASK ~202

PROCESSING THE SUBSTRATE ~204

ASSEMBLING THE DEVICE ~205

INSPECTING ~206

(SHIPPING)

<div align="center">**INTERNATIONAL SEARCH REPORT**</div>

| International application No. |
| --- |
| PCT/JP2006/308648 |

**A. CLASSIFICATION OF SUBJECT MATTER**
*H01L21/027*(2006.01)i, *G03F7/20*(2006.01)i

According to International Patent Classification (IPC) or to both national classification and IPC

**B. FIELDS SEARCHED**

Minimum documentation searched (classification system followed by classification symbols)
H01L21/027, G03F7/20

Documentation searched other than minimum documentation to the extent that such documents are included in the fields searched
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2005-12195 A (Nikon Corp.),<br>13 January, 2005 (13.01.05),<br>Claims; Par. Nos. [0027], [0052] to [0056],<br>[0071], [0084] to [0087], [0091] to [0095];<br>Figs. 1, 5, 6<br>& WO 2004/105106 A1 & EP 1632991 A1<br>& US 2006/098177 A1 | 1,2,4-32 |
| A | JP 2003-270117 A (Seiko Epson Corp.),<br>25 September, 2003 (25.09.03),<br>Full text; all drawings<br>(Family: none) | 1-32 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>27 July, 2006 (27.07.06) | Date of mailing of the international search report<br>08 August, 2006 (08.08.06) |
| --- | --- |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

| International application No. |
| --- |
| PCT/JP2006/308648 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | JP 2004-207711 A  (Nikon Corp.),<br>22 July, 2004 (22.07.04),<br>Full text; all drawings<br>& WO 2004/053956 A1      & AU 2003289271 A1<br>& US 2005/237504 A1      & EP 1571698 A1<br>& CN 1723539 A          & US 2006/132736 A1 | 1-32 |
| P,A | JP 2005-223315 A  (Nikon Corp.),<br>18 August, 2005 (18.08.05),<br>Full text; all drawings<br>& WO 2005/067013 A1 | 1-32 |
| P,A | WO 2005/076321 A1  (Nikon Corp.),<br>18 August, 2005 (18.08.05),<br>Full text; all drawings<br>(Family: none) | 1-32 |
| P,A | JP 2005-252246 A  (Nikon Corp.),<br>15 September, 2005 (15.09.05),<br>Full text; all drawings<br>& WO 2005/076325 A1 | 1-32 |
| P,A | JP 2005-286286 A  (Nikon Corp.),<br>13 October, 2005 (13.10.05),<br>Full text; all drawings<br>(Family: none) | 1-32 |
| P,A | WO 2005/124833 A1  (Nikon Corp.),<br>29 December, 2005 (29.12.05),<br>Full text; all drawings<br>& JP 2006-165502 A | 1-32 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005129517 A
- JP 2005211319 A
- WO 9949504 A
- WO 2004019128 A
- JP H10163099 A
- JP H10214783 A
- JP 2000505958 W
- JP H11135400 A
- JP 2000164504 A
- JP H6124873 A
- JP H10303114 A
- US 5825043 A
- US 6778257 B
- WO 2001035168 A